# EUROPEAN PATENT APPLICATION

(11) **EP 4 629 805 A1**
(43) Date of publication of application: **08.10.2025**
(21) Application number: 25167846.2
(22) Date of filing: 01.04.2025
(51) Int. Cl.: H10K 59/131

(54) **DISPLAY APPARATUS**

(30) Priority: 03.04.2024 KR 20240045510
(71) Applicant: Samsung Display Co., Ltd., Yongin-si, Gyeonggi-do 17113 (KR)
(72) Inventor: JANG, Soyoung, 17113 Yongin-si (KR); KIM, Hansol, 17113 Yongin-si (KR); NOH, Jaedu, 17113 Yongin-si (KR); Youngjin, CHO, 17113 Yongin-si (KR)
(74) Representative: Walaski, Jan Filip

(57) **Abstract**

A display apparatus includes a first pixel circuit and a second pixel circuit adjacent to each other in a first direction, and a first conductive layer over the first pixel circuit and the second pixel circuit and including a first data line, a second data line, a first voltage line overlapping the first pixel circuit, and a second voltage line overlapping the second pixel circuit, wherein each of the first pixel circuit and the second pixel circuit includes a first transistor including a first semiconductor pattern and a first gate electrode, a second transistor including a second semiconductor pattern and a second gate electrode, and a connection electrode connecting the first transistor and the second transistor to each other, wherein the connection electrode of the second pixel circuit is arranged between the first voltage line and the first data line in a plan view.

## Description

### CROSS-REFERENCE TO RELATED APPLICATION

The present application claims priority to Korean Patent Application No. 10-2024-0045510, filed on 3 April 2024 in the Korean Intellectual Property Office.

### BACKGROUND

### 1. Field

The disclosure relates to a display apparatus.

### 2. Description of the Related Art

Recently, display apparatuses have become relatively thinner and lighter and thus their uses have diversified. Each of such display apparatuses may include a plurality of pixels. Each pixel may include a light emitting diode and a pixel circuit for controlling the luminance of the light emitting diode or the like. The pixel circuit may include transistors and capacitors connected to lines such as data lines, gate lines, and voltage lines.

As display apparatuses have been widely used and functions capable of being combined with or connected to display apparatuses have increased, various types of display apparatuses have been designed.

The above information disclosed in this Background section is only for enhancement of understanding of the background and therefore the information discussed in this Background section does not necessarily constitute prior art.

### SUMMARY

Aspects of one or more embodiments include a display apparatus that displays high-quality images. However, these characteristics are merely examples and the scope of embodiments according to the present disclosure is not limited thereto.

Additional aspects will be set forth in part in the description which follows and, in part, will be apparent from the description, or may be learned by practice of the presented embodiments of the disclosure.

According to some embodiments of the present disclosure, a display apparatus includes a first pixel circuit and a second pixel circuit over a substrate and adjacent to each other in a first direction, and a first conductive layer over the first pixel circuit and the second pixel circuit and including a first data line connected to the first pixel circuit, a second data line connected to the second pixel circuit, a first voltage line overlapping the first pixel circuit, and a second voltage line overlapping the second pixel circuit, wherein each of the first pixel circuit and the second pixel circuit includes a first transistor including a first semiconductor pattern and a first gate electrode over the first semiconductor pattern, a second transistor including a second semiconductor pattern over the first semiconductor pattern and a second gate electrode over the second semiconductor pattern, and a connection electrode connecting one terminal of the first transistor and one terminal of the second transistor to each other, wherein the connection electrode of the second pixel circuit is arranged between the first voltage line and the first data line in a plan view.

According to some embodiments, the display apparatus may further include a second conductive layer over the first conductive layer and including a first pixel electrode connected to the first pixel circuit and a second pixel electrode connected to the second pixel circuit, and a pixel definition layer over the second conductive layer and defining a first pixel opening overlapping the first pixel electrode and a second pixel opening overlapping the second pixel electrode, wherein the first data line are arranged apart from the first pixel opening and the second pixel opening in a plan view.

According to some embodiments, the first pixel opening and the second pixel opening may overlap the first voltage line.

According to some embodiments, a portion of the first voltage line overlapping the first pixel opening may be axisymmetric with respect to a virtual straight line passing through a center of the first pixel opening.

According to some embodiments, the display apparatus may further include a third pixel circuit over the substrate and adjacent to the second pixel circuit in the first direction, wherein the first conductive layer may further include a third data line connected to the third pixel circuit and a third voltage line overlapping the third pixel circuit.

According to some embodiments, the second conductive layer may further include a third pixel electrode connected to the third pixel circuit, the pixel definition layer may further define a third pixel opening overlapping the third pixel electrode, and the second data line may overlap the third pixel opening.

According to some embodiments, the first conductive layer may further include a first voltage transmission line extending in a second direction intersecting with the first direction and overlapping the third pixel opening, and a portion of the first voltage transmission line and a portion of the second data line overlapping the third pixel opening may be axisymmetric with respect to a virtual straight line passing through a center of the third pixel opening.

According to some embodiments, each of the first pixel circuit and the second pixel circuit may further include a conductive pattern over the first gate electrode, and the conductive pattern of the second pixel circuit may extend to an area in which the first data line and a drain area of the first transistor of the second pixel circuit overlap each other.

According to some embodiments, the display apparatus may further include a third conductive layer over the conductive pattern and including a second voltage transmission line connected to the first voltage line, the second voltage line, and the conductive pattern.

According to some embodiments, the first semiconductor pattern may include a silicon-based semiconductor material, and the second semiconductor pattern may include an oxide-based semiconductor material.

According to some embodiments of the present disclosure, a display apparatus includes a first semiconductor layer over a substrate and including a first semiconductor pattern and a second semiconductor pattern arranged adjacent to each other in a first direction, a first conductive layer over the first semiconductor layer, a second conductive layer over the first conductive layer and including a conductive pattern, a second semiconductor layer over the second conductive layer and including a third semiconductor pattern and a fourth semiconductor pattern, a third conductive layer over the second semiconductor layer, a fourth conductive layer over the third conductive layer and including a first connection electrode connecting the first semiconductor pattern and the third semiconductor pattern to each other and a second connection electrode connecting the second semiconductor pattern and the fourth semiconductor pattern to each other, and a fifth conductive layer over the fourth conductive layer and including a first voltage line, a first data line, a second voltage line, and a second data line sequentially arranged in the first direction, wherein the first data line is connected to the first semiconductor pattern, the second data line is connected to the second semiconductor pattern, and the second connection electrode is arranged between the first voltage line and the first data line in a plan view.

According to some embodiments, the display apparatus may further include a sixth conductive layer over the fifth conductive layer and including a first pixel electrode and a second pixel electrode overlapping the first voltage line, and a pixel definition layer over the sixth conductive layer and defining a first pixel opening overlapping the first pixel electrode and a second pixel opening overlapping the second pixel electrode, wherein the first data line may be arranged apart from the first pixel opening and the second pixel opening in a plan view.

According to some embodiments, a portion of the first voltage line overlapping the first pixel opening may be axisymmetric with respect to a virtual straight line passing through a center of the first pixel opening.

According to some embodiments, a portion of the first voltage line overlapping the second pixel opening may be axisymmetric with respect to a virtual straight line passing through a center of the first pixel opening.

According to some embodiments, the fifth conductive layer may further include a first voltage transmission line, a third voltage line, and a third data line sequentially arranged from the second data line in the first direction, and the sixth conductive layer may further include a third pixel electrode overlapping the second voltage line, the second data line, the first voltage transmission line, and the third voltage line.

According to some embodiments, the pixel definition layer may further define a third pixel opening overlapping the third pixel electrode, and the second data line and the first voltage transmission line may overlap the third pixel opening.

According to some embodiments, a portion of the first voltage transmission line and a portion of the second data line overlapping the third pixel opening may be axisymmetric with respect to a virtual straight line passing through a center of the third pixel opening.

According to some embodiments, the conductive pattern may extend to an area in which the first data line and the second semiconductor pattern overlap each other.

According to some embodiments, the fourth conductive layer may further include a second voltage transmission line connected to the first voltage line, the second voltage line, and the conductive pattern.

According to some embodiments, the first semiconductor pattern may include a silicon-based semiconductor material, and the second semiconductor pattern may include an oxide-based semiconductor material.

Other aspects, features, and characteristics other than those described above will become apparent from the accompanying drawings, the appended claims and their equivalents, and the detailed description of the disclosure.

### BRIEF DESCRIPTION OF THE DRAWINGS

The above and other aspects, features, and characteristics of certain embodiments of the disclosure will be more apparent from the following description taken in conjunction with the accompanying drawings, in which:
FIGS. 1A and 1B are each a plan view schematically illustrating a display apparatus;
FIG. 2 is a diagram schematically illustrating a display apparatus;
FIG. 3 is an equivalent circuit diagram of a pixel included in a display apparatus;
FIG. 4 is a layout diagram schematically illustrating a portion of a display apparatus;
FIGS. 5 to 15 are each a layout diagram schematically illustrating a portion of a display apparatus on a layer-by-layer basis;
FIGS. 16 and 17 are each a cross-sectional view schematically illustrating a display apparatus;
FIG. 18A is a layout diagram schematically illustrating pixel electrodes, voltage lines, and data lines of a display apparatus; and
FIG. 18B is a cross-sectional view schematically illustrating a display apparatus.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Throughout the disclosure, the expression "at least one of a, b or c" indicates only a, only b, only c, both a and b, both a and c, both b and c, all of a, b, and c, or variations thereof.

The disclosure may include various embodiments and modifications, and particular embodiments thereof are illustrated in the drawings and will be described herein in detail. The effects and features of the disclosure and the accomplishing methods thereof will become apparent from the embodiments described below in detail with reference to the accompanying drawings. However, the disclosure is not limited to the embodiments described below, and may be embodied in various modes.

Hereinafter, embodiments will be described in detail with reference to the accompanying drawings, and in the following description, like reference numerals will denote like elements and some redundant descriptions thereof may be omitted.

It will be understood that although terms such as "first" and "second" may be used herein to describe various components, these components should not be limited by these terms and these terms are only used to distinguish one component from another component.

As used herein, the singular forms "a," "an," and "the" are intended to include the plural forms as well, unless the context clearly indicates otherwise.

Also, it will be understood that the terms "comprise," "include," and "have" used herein specify the presence of stated features or components, but do not preclude the presence or addition of one or more other features or components.

It will be understood that when a layer, region, or component is referred to as being "on" another layer, region, or component, it may be "directly on" the other layer, region, or component or may be "indirectly on" the other layer, region, or component with one or more intervening layers, regions, or components therebetween.

It will be understood that when a layer, region, or component is referred to as being "connected to" another layer, region, or component, it may be "directly connected to" the other layer, region, or component or may be "indirectly connected to" the other layer, region, or component with one or more intervening layers, regions, or components therebetween. For example, it will be understood that when a layer, region, or component is referred to as being "electrically connected to" another layer, region, or component, it may be "directly electrically connected to" the other layer, region, or component and/or may be "indirectly electrically connected to" the other layer, region, or component with one or more intervening layers, regions, or components therebetween.

Herein, the x direction, the y direction, and the z direction are not limited to the directions along three axes of the rectangular coordinate system and may be interpreted in a broader sense. For example, the x direction, the y direction, and the z direction may be perpendicular to one another or may represent different directions that are not perpendicular to one another.

Herein, when referred to as "in a plan view," it may mean that a target portion is viewed from above (e.g., viewed in a direction perpendicular to the upper surface of a substrate), and when referred to as "in a cross-sectional view," it may mean that a cross-section of a target portion vertically cut is viewed from side.

Herein, when a first element "overlaps" a second element, the first element may be located over or under the second element such that they may at least partially overlap each other in the plan view.

Sizes of elements in the drawings may be exaggerated for convenience of description. In other words, because the sizes and shapes of components in the drawings are arbitrarily illustrated for convenience of description, the disclosure is not limited thereto.

As the resolution of a display apparatus increases, the distance between a data line and a driving transistor adjacent thereto may decrease and the parasitic capacitance between the data line and the driving transistor may increase. Accordingly, when an electrical signal is applied to the data line, the luminance of adjacent pixels changes and thus a stain may occur in an image displayed by the display apparatus. Aspects of one or more embodiments include a display apparatus that displays a high-quality image.

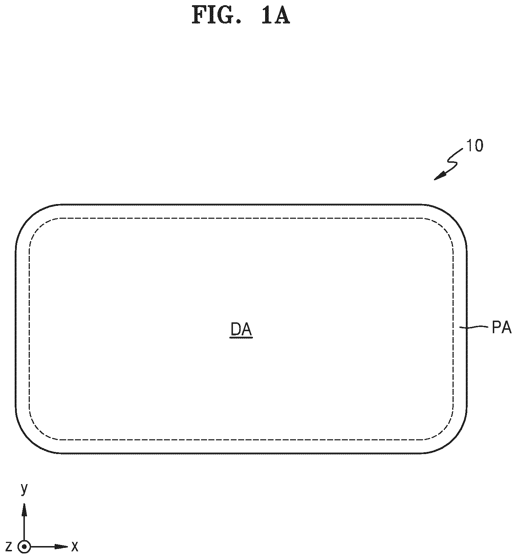

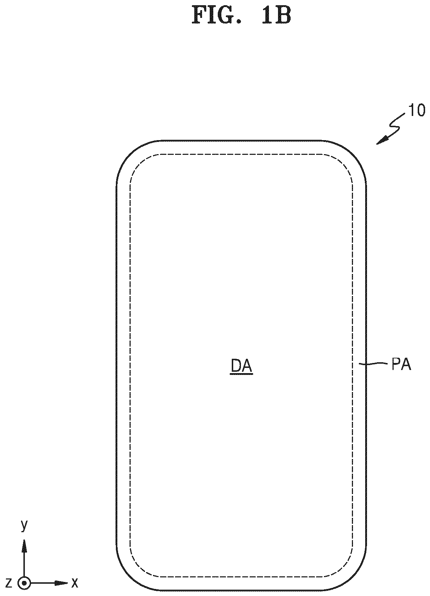

FIGS. 1A and 1B are each a plan view schematically illustrating a display apparatus.

Referring to FIGS. 1A and 1B, a display apparatus 10 may include a display area DA displaying images and a peripheral area PA outside the display area DA. The display apparatus 10 may provide a certain image by using light emitted from a plurality of pixels arranged in the display area DA. The display area DA may have a rectangular shape in the plan view. The display area DA may have other polygonal shapes, a circular shape, an elliptical shape, an atypical shape, or the like. A corner of the edge of the display area DA may be rounded.

The display apparatus 10 may include a display area DA that is longer in a first direction (x direction) than in a second direction (y direction), as illustrated in FIG. 1A. The display apparatus 10 may include a display area DA that is shorter in the first direction (x direction) than in the second direction (y direction), as illustrated in FIG. 1B.

The peripheral area PA may be an area arranged around the display area DA, and the peripheral area PA may surround at least a portion of the display area DA. The peripheral area PA may be a non-display area in which pixels are not arranged. Various lines for transmitting electrical signals to be applied to the display area DA, circuits, and/or pads to which a printed circuit board or a driver IC chip is attached may be located in the peripheral area PA.

The display apparatus 10 may be an apparatus displaying a moving image or a still image and may be used as a display screen of various products such as televisions, notebook computers, monitors, billboards, and Internet of Things (IoT) devices as well as portable electronic apparatuses such as mobile phones, smart phones, tablet personal computers (PCs), mobile communication terminals, electronic notebooks, electronic books, portable multimedia players (PMPs), navigation devices, and Ultra Mobile PCs (UMPCs). Also, the display apparatus 10 may be used in wearable devices such as smart watches, watch phones, glasses-type displays, and head-mounted displays (HMDs). Also, the display apparatus 10 may be used as a center information display (CID) arranged at a vehicle's instrument panel or a vehicle's center fascia or dashboard, a mirror display replacing a vehicle's side mirror, or a display arranged at a rear side of a vehicle's front seat as entertainment for a vehicle's rear seat.

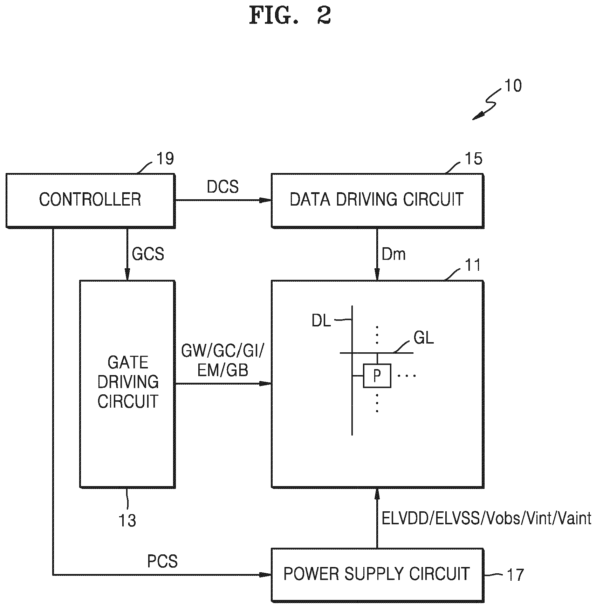

FIG. 2 is a diagram schematically illustrating a display apparatus.

Referring to FIG. 2, a display apparatus 10 may include a pixel unit 11, a gate driving circuit 13, a data driving circuit 15, a power supply circuit 17, and a controller 19.

The pixel unit 11 may be included in a display area DA (see FIG. 1A) of the display apparatus 10, and the gate driving circuit 13, the data driving circuit 15, the power supply circuit 17, and the controller 19 may be included in a peripheral area PA (see FIG. 1A).

A plurality of gate lines GL, a plurality of data lines DL, and a plurality of pixels P connected thereto may be arranged in the pixel unit 11. Each of the pixels P may refer to a subpixel. Each of the pixels P may include a pixel circuit and a display element connected to the pixel circuit. The pixel circuit may include a plurality of transistors and at least one capacitor. The display element may be an organic light emitting diode.

The pixels P may emit red, green, and blue light. The pixels P may emit red, green, blue, and white light. The pixel circuit of each pixel P may be connected to at least one corresponding gate line among the plurality of gate lines GL and a corresponding data line among the plurality of data lines DL.

The data lines DL may be connected to the pixels P, the pixel circuits of which are located in the same column. The data lines DL may be configured to transmit a data signal to the connected pixels P in synchronization with each gate signal. The gate lines GL may be connected to the pixels P, the pixel circuits of which are located in the same row. The gate lines GL may be configured to transmit a gate signal to the connected pixels P.

The gate driving circuit 13 may be connected to the plurality of gate lines GL. The gate driving circuit 13 may generate gate signals GW, GI, GC, GB, and EM in response to a control signal GCS from the controller 19 and sequentially supply the same to each of the gate lines GL. Each gate line GL may be connected to a gate of a transistor included in the pixel circuit. Each of the gate signals GW, GI, GC, GB, and EM may be a gate control signal for controlling the turn-on and turn-off of the transistor to which the corresponding gate line is connected. Each of the gate signals GW, GI, GC, GB, and EM may be a square wave signal including an on voltage at which the transistor may be turned on and an off voltage at which the transistor may be turned off.

FIG. 2 illustrates that one pixel P is connected to one gate line GL; however, this is only an example and one pixel P may be connected to two or more gate lines and the gate driving circuit 13 may supply, to the two or more gate lines, two or more gate signals GW, GI, GC, GB, and EM with different timings at which an on voltage is applied. For example, the pixel P may be connected to first to fifth gate lines, and the gate driving circuit 13 may apply a first gate signal GW, a second gate signal GC, a third gate signal GI, a fourth gate signal GB, and an emission control signal (or a fifth gate signal) EM to the first gate line, the second gate line, the third gate line, the fourth gate line, and the fifth gate line respectively.

The data driving circuit 15 may be connected to the plurality of data lines DL. In response to a control signal DCS from the controller 19, the data driving circuit 15 may convert input image data with a gradation input from the controller 19 into a data signal Dm and supply the data signal Dm to the data lines DL.

In response to a control signal PCS from the controller 19, the power supply circuit 17 may generate voltages necessary for driving the pixel P. The power supply circuit 17 may generate a first power voltage ELVDD and a second power voltage ELVSS and supply the same to the pixels P. The first power voltage ELVDD may be a high-level voltage provided to a first electrode (pixel electrode or anode) of the display element included in the pixel P. The second power voltage ELVSS may be a low-level voltage provided to a second electrode (opposite electrode or cathode) of the display element included in the pixel P. The power supply circuit 17 may generate a first initialization voltage Vint, a second initialization voltage Vaint, and a bias voltage Vobs and supply the same to the pixels P.

The power supply circuit 17 may supply a second initialization voltage Vaint having a different level for each pixel P. For example, the power supply circuit 17 may supply a 2nd-1 initialization voltage to a first pixel emitting light of a first color through a 2nd-1 initialization voltage line and may supply a 2nd-2 initialization voltage to a second pixel emitting light of a second color different from the first color through a 2nd-2 initialization voltage line. In this case, the 2nd-1 initialization voltage and the 2nd-2 initialization voltage may have different levels.

The controller 19 may generate control signals GCS, DCS, and PCS based on signals input from outside and respectively supply the control signals GCS, DCS, and PCS to the gate driving circuit 13, the data driving circuit 15, and the power supply circuit 17. The control signal GCS output to the gate driving circuit 13 may include a gate start signal and clock signals. The control signal DCS output to the data driving circuit 15 may include a source start signal and clock signals.

Some or all portions of the gate driving circuit 13 may be directly formed in a peripheral area PA (see FIG. 1A) of the substrate. Each of the data driving circuit 15, the power supply circuit 17, and the controller 19 may be formed in the form of a separate integrated circuit chip or a single integrated circuit chip and located over a flexible printed circuit board electrically connected to a pad arranged on one side of the substrate. At least some of the data driving circuit 15, the power supply circuit 17, and the controller 19 may be directly located over the substrate by using a chip-on-glass (COG) or chip-on-plastic (COP) method.

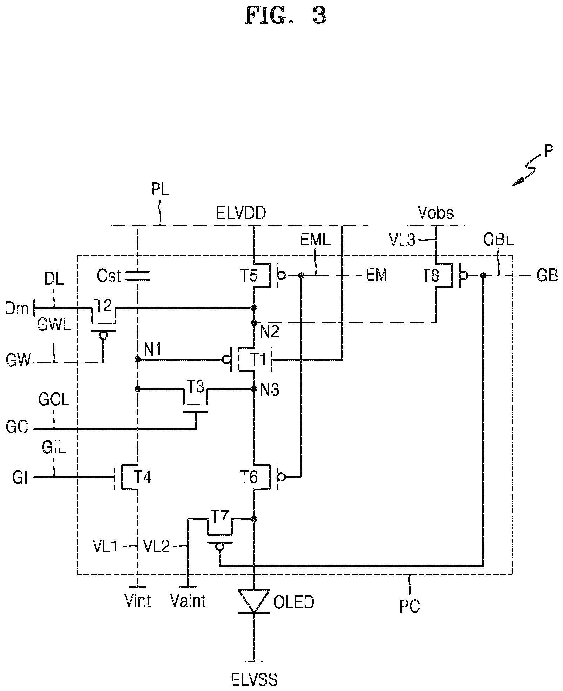

FIG. 3 is an equivalent circuit diagram of a pixel included in a display apparatus. Although FIG. 3 illustrates various components in a pixel P, they are not limited thereto. The pixel P may include additional components or fewer components.

Referring to FIG. 3, a pixel P may include an organic light emitting diode OLED as a display element and a pixel circuit PC electrically connected to the organic light emitting diode OLED. The pixel circuit PC may include first to eighth transistors T1 to T8 and a storage capacitor Cst. The first transistor T1 may be a driving transistor outputting a driving current corresponding to a data signal Dm, and each of the second to eighth transistors T2 to T8 may be a switching transistor configured to transmit a signal.

A first terminal (first electrode) of each of the first to eighth transistors T1 to T8 may be a source or a drain, and a second terminal (second electrode) thereof may be a terminal different from the first terminal. For example, when the first terminal is a drain, the second terminal may be a source.

A node to which a gate of the first transistor T1 is connected may be defined as a first node N1, a node to which a first terminal of the first transistor T1 is connected may be defined as a second node N2, and a node to which a second terminal of the first transistor T1 is connected may be defined as a third node N3.

The pixel circuit PC of each pixel P may be connected to a first gate line GWL configured to transmit a first gate signal GW, a second gate line GCL configured to transmit a second gate signal GC, a third gate line GIL configured to transmit a third gate signal GI, a fourth gate line GBL configured to transmit a fourth gate signal GB, an emission control line (fifth gate line) EML configured to transmit an emission control signal EM, a data line DL configured to transmit a data signal Dm, a driving voltage line PL configured to transmit a first power voltage ELVDD, a first initialization voltage line VL1 configured to transmit a first initialization voltage Vint, a second initialization voltage line VL2 configured to transmit a second initialization voltage Vaint, and a bias voltage line VL3 configured to transmit a bias voltage Vobs.

The first transistor T1 may include a gate (or a gate electrode) connected to the first node N1, a first terminal connected to the second node N2, and a second terminal connected to the third node N3. The first terminal of the first transistor T1 may be connected to the driving voltage line PL via the fifth transistor T5, and the second terminal of the first transistor T1 may be connected to the pixel electrode (anode) of the organic light emitting diode OLED via the sixth transistor T6. The first transistor T1 may receive the data signal Dm according to a switching operation of the second transistor T2 to control the amount of a driving current flowing through the pixel electrode of the organic light emitting diode OLED.

The second transistor T2 may be connected between the data line DL and the first transistor T1. The second transistor T2 may include a gate connected to the first gate line GWL, a first terminal connected to the data line DL, and a second terminal connected to the second node N2. The second transistor T2 may be turned on by the first gate signal GW received through the first gate line GWL, to electrically connect the data line DL with the second node N2 and transmit the data signal Dm from the data line DL to the second node N2.

The third transistor T3 may be connected between the gate of the first transistor T1 and the second terminal of the first transistor T1. The third transistor T3 may include a gate connected to the second gate line GCL, a first terminal connected to the first node N1, and a second terminal connected to the third node N3. The third transistor T3 may be turned on by the second gate signal GC received through the second gate line GCL, to diode-connect the gate of the first transistor T1 with the second terminal of the first transistor T1.

The fourth transistor T4 may be connected between the first initialization voltage line VL1 and the gate of the first transistor T1. The fourth transistor T4 may include a gate connected to the third gate line GIL, a first terminal connected to the first node N1, and a second terminal connected to the first initialization voltage line VL1. The fourth transistor T4 may be turned on by the third gate signal GI received through the third gate line GIL, to transmit the first initialization voltage Vint from the first initialization voltage line VL1 to the first node N1 to initialize the first node N1.

The fifth transistor T5 may be connected between the driving voltage line PL and the first transistor T1. The fifth transistor T5 may include a gate connected to the emission control line EML, a first terminal connected to the driving voltage line PL, and a second terminal connected to the second node N2.

The sixth transistor T6 may be connected between the first transistor T1 and the organic light emitting diode OLED. The sixth transistor T6 may include a gate connected to the emission control line EML, a first terminal connected to the third node N3, and a second terminal connected to the pixel electrode of the organic light emitting diode OLED. The fifth transistor T5 and the sixth transistor T6 may be simultaneously turned on by the emission control signal EM received through the emission control line EML, and thus, a driving current may flow through the pixel electrode of the organic light emitting diode OLED.

The seventh transistor T7 may be connected between the second initialization voltage line VL2 and the organic light emitting diode OLED. The seventh transistor T7 may include a gate connected to the fourth gate line GBL, a first terminal connected to the second initialization voltage line VL2, and a second terminal connected to the pixel electrode of the organic light emitting diode OLED. The seventh transistor T7 may be turned on by the fourth gate signal GB received through the fourth gate line GBL and may be configured to transmit the second initialization voltage Vaint from the second initialization voltage line VL2 to the pixel electrode of the organic light emitting diode OLED to initialize the pixel electrode of the organic light emitting diode OLED. The seventh transistor T7 may provide a bypass current path other than the current path to the organic light emitting diode OLED, and thus, the display apparatus 10 (see FIG. 1A) may display an image with a higher contrast ratio.

The eighth transistor T8 may be connected between the bias voltage line VL3 and the first transistor T1. The eighth transistor T8 may include a gate connected to the fourth gate line GBL, a first terminal connected to the second node N2, and a second terminal connected to the bias voltage line VL3. The eighth transistor T8 may be turned on by the fourth gate signal GB received through the fourth gate line GBL, to transmit the bias voltage Vobs from the bias voltage line VL3 to the second node N2. The eighth transistor T8 may be configured to control the voltage of the second node N2 to improve a luminance deviation caused by the difference in electrical characteristics between the pixels P. Also, when the display apparatus 10 supports a variable refresh rate, a color coordinate change may be reduced in the case of high-frequency driving and the degradation of the first transistor T1 may be prevented or reduced in the case of low-frequency driving.

The storage capacitor Cst may be connected between the driving voltage line PL and the gate of the first transistor T1. A first capacitor electrode of the storage capacitor Cst may be connected to the first node N1, and a second capacitor electrode thereof may be connected to the driving voltage line PL. The storage capacitor Cst may store a threshold voltage of the first transistor T1 and a voltage corresponding to the data signal Dm.

The organic light emitting diode OLED may include a pixel electrode (e.g., an anode), an opposite electrode (e.g., a cathode) facing the pixel electrode, and an intermediate layer arranged between the pixel electrode and the opposite electrode. The opposite electrode may be supplied with a second power voltage ELVSS and may be provided as a common layer common to a plurality of pixels P.

Some of the first to eighth transistors T1 to T8 may be P-channel transistors, and the others may be N-channel transistors. The first transistor T1, the second transistor T2, and the fifth to eighth transistors T5 to T8 may be P-channel transistors, and the third transistor T3 and the fourth transistor T4 may be N-channel transistors. All of the first to eighth transistors T1 to T8 may be N-channel transistors or may be P-channel transistors.

Some of the transistors included in the pixel circuit PC may be oxide thin film transistors, and the other transistors may be silicon thin film transistors. For example, the first transistor T1, the second transistor T2, and the fifth to eighth transistors T5 to T8 may be silicon thin film transistors, and the third transistor T3 and the fourth transistor T4 may be oxide thin film transistors. The oxide thin film transistor may have an active pattern including an oxide-based semiconductor material. The silicon thin film transistor may be a low-temperature polysilicon (LTPS) thin film transistor in which an active pattern includes a silicon-based semiconductor material such as amorphous silicon or polysilicon.

FIG. 3 illustrates that the pixel circuit PC includes the first to eighth transistors T1 to T8 and the storage capacitor Cst; however, the disclosure is not limited thereto. The design thereof may be variously modified, such as omitting some of the transistors and capacitors therefrom or adding additional transistors and capacitors thereto.

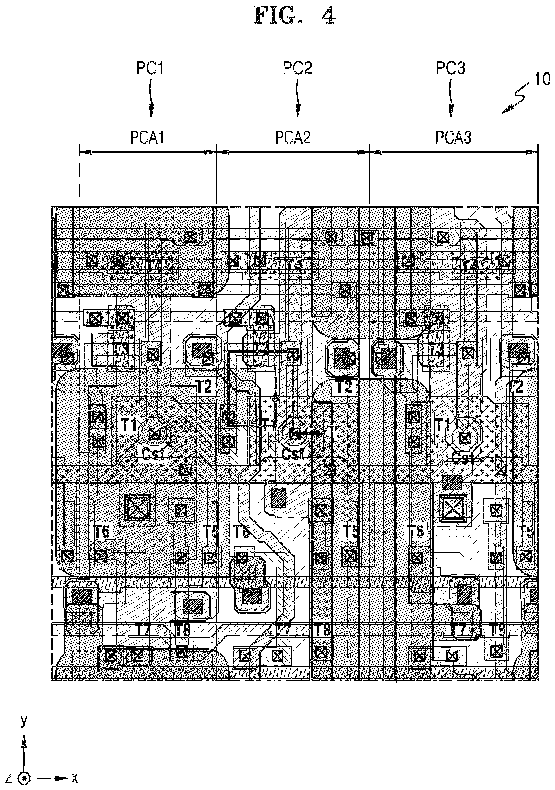

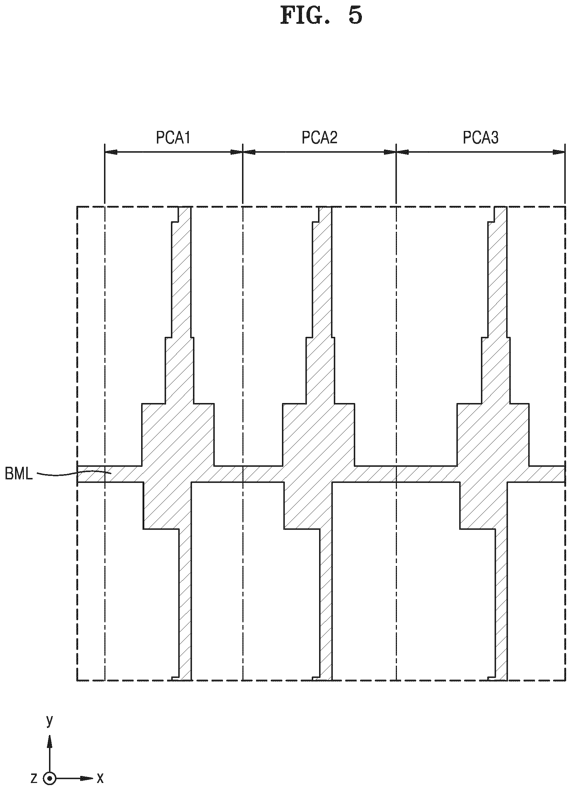

FIG. 4 is a layout diagram schematically illustrating a portion of a display apparatus, and FIGS. 5 to 15 are each a layout diagram schematically illustrating a portion of a display apparatus on a layer-by-layer basis.

As illustrated in FIGS. 4 to 15, a display area DA (see FIG. 1A) of a display apparatus 10 may include a first area PCA1 in which a first pixel circuit PC1 is arranged, a second area PCA2 in which a second pixel circuit PC2 is arranged, and a third area PCA3 in which a third pixel circuit PC3 is arranged. The first pixel circuit PC1, the second pixel circuit PC2, and the third pixel circuit PC3 may be sequentially arranged adjacent to each other in the first direction (x direction). The first pixel circuit PC1 may be connected to a first organic light emitting diode emitting light in a first color, the second pixel circuit PC2 may be connected to a second organic light emitting diode emitting light in a second color, and the third pixel circuit PC3 may be connected to a third organic light emitting diode emitting light in a third color.

The first pixel circuit PC1, the second pixel circuit PC2, and the third pixel circuit PC3 may include similar or same components. Hereinafter, the components of the first pixel circuit PC1 will be described as a reference, and unless otherwise specified, each of the second pixel circuit PC2 and the third pixel circuit PC3 may include components corresponding to the components of the first pixel circuit PC1.

The structure illustrated in FIGS. 4 to 15 may be repeatedly arranged in the first direction (x direction) and the second direction (y direction). Hereinafter, descriptions will be given with reference to FIGS. 4 to 15 together.

FIG. 5 illustrates a lower conductive layer BML. The lower conductive layer BML may include a body portion, a first connection portion extending from the body portion in the first direction (x direction), and a second connection portion extending from the body portion in the second direction (y direction). The body portion of the lower conductive layer BML may overlap a channel area A1 of the first transistor T1 to prevent or reduce degradation of the first transistor T1 due to external light or the like.

The lower conductive layer BML may include a conductive material such as molybdenum (Mo), aluminum (Al), copper (Cu), titanium (Ti), indium tin oxide (ITO), or indium zinc oxide (IZO) and may include a single layer or multiple layers including the above material. For example, the lower conductive layer BML may have a molybdenum (Mo) single layer structure.

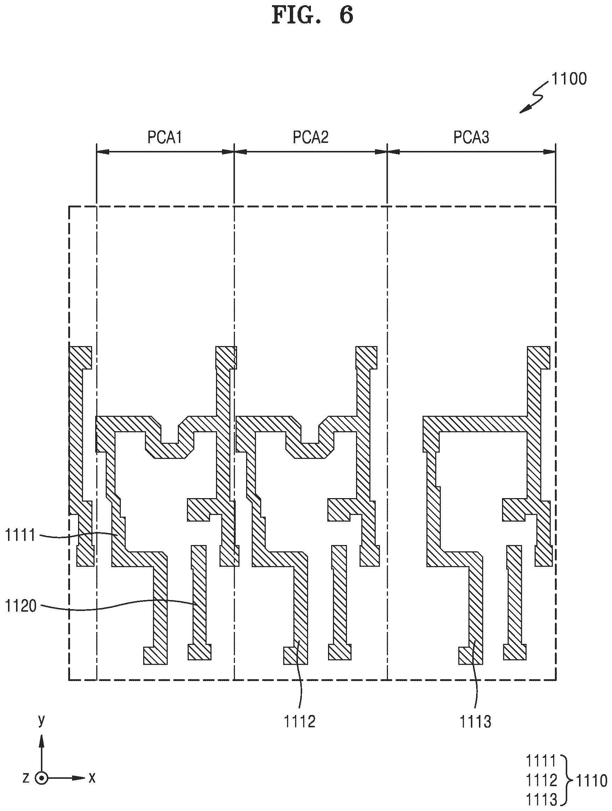

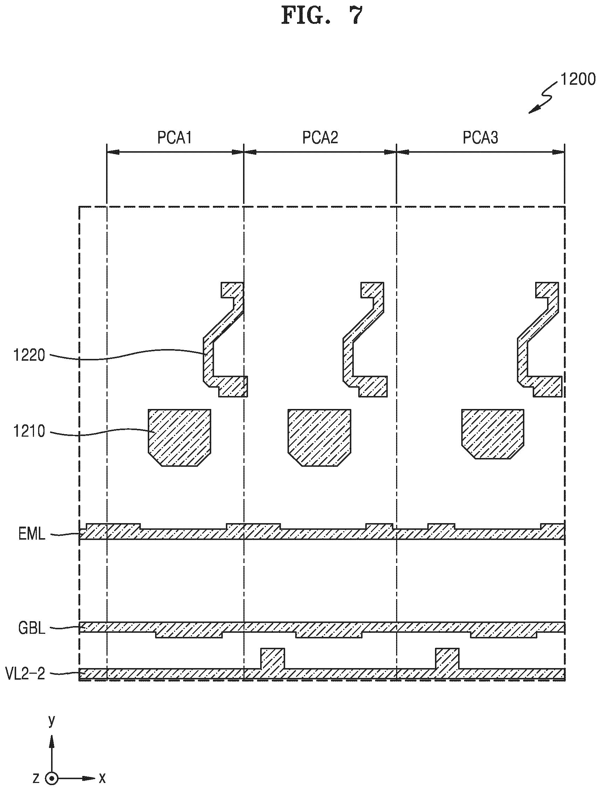

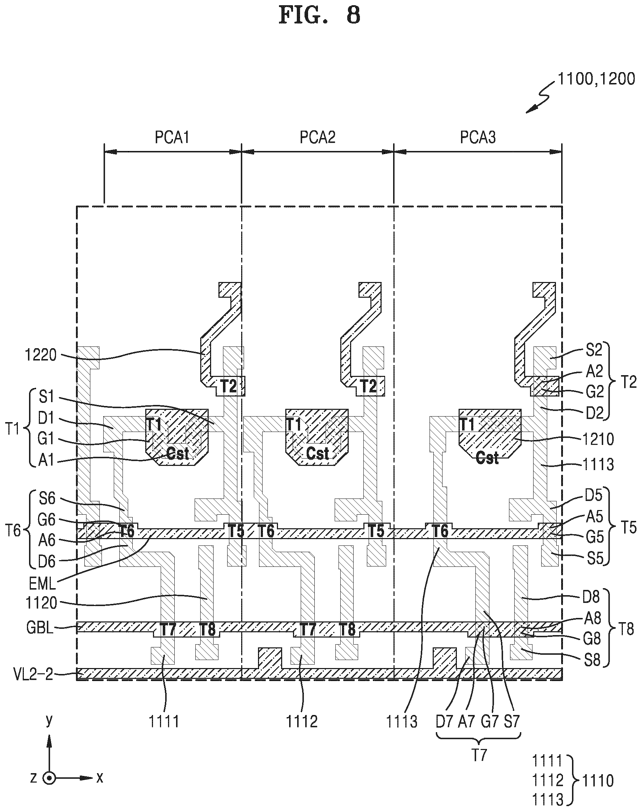

FIG. 6 illustrates a first semiconductor layer 1100 located over the lower conductive layer BML, and FIG. 7 illustrates a first conductive layer 1200 located over the first semiconductor layer 1100. For convenience of description, FIG. 8 illustrates the first semiconductor layer 1100 and the first conductive layer 1200 in an overlapping manner. At least one insulating layer may be arranged between the lower conductive layer BML and the first semiconductor layer 1100 and between the first semiconductor layer 1100 and the first conductive layer 1200. The first semiconductor layer 1100 may include a silicon-based semiconductor material such as amorphous silicon or polycrystalline silicon. The first conductive layer 1200 may include a conductive material such as molybdenum (Mo), aluminum (Al), copper (Cu), or titanium (Ti) and may include a single layer or multiple layers including the above material. For example, the first conductive layer 1200 may have a molybdenum (Mo) single layer structure.

The first semiconductor layer 1100 may include a first semiconductor pattern 1110 and a second semiconductor pattern 1120 spaced apart from the first semiconductor pattern 1110. The first semiconductor pattern 1110 may include a channel area A1 of the first transistor T1, a channel area A2 of the second transistor T2, a channel area A5 of the fifth transistor T5, a channel area A6 of the sixth transistor T6, and a channel area A7 of the seventh transistor T7, and each of the second semiconductor patterns 1120 may include a channel area A8 of the eighth transistor T8. A source area and a drain area may be arranged on both sides of each of the channel areas A1, A2, A5, A6, A7, and A8. Source areas S1, S2, S5, S6, S7, and S8 and drain areas D1, D2, D5, D6, D7, and D8 may be doped areas.

For convenience of illustration, FIG. 8 illustrates the gate electrodes, channel areas, source areas, and drain areas of the transistors in the first pixel circuit PC1 and the third pixel circuit PC3 in a divided manner; however, it may be understood that the gate electrodes G1, G2, G5, G6, G7 and G8, channel areas A1, A2, A5, A6, A7 and A8, source areas S1, S2, S5, S6, S7 and S8, and drain areas D1, D2, D5, D6, D7 and D8 of the first transistor T1, the second transistor T2, the fifth transistor T5, the sixth transistor T6, the seventh transistor T7, and the eighth transistor T8 are also arranged at the corresponding positions in each of the first pixel circuit PC1, the second pixel circuit PC2 and the third pixel circuit PC3.

The first semiconductor pattern 1110 may include a 1st-1 semiconductor pattern 1111 arranged in the first area PCA1, a 1st-2 semiconductor pattern 1112 arranged in the second area PCA2, and a 1st-3 semiconductor pattern 1113 arranged in the third area PCA3. For example, each of the first to third pixel circuits PC1, PC2, and PC3 may include a first semiconductor pattern 1110, and the first semiconductor pattern 1110 of the first pixel circuit PC1 may be referred to as a 1st-1 semiconductor pattern 1111, the first semiconductor pattern 1110 of the second pixel circuit PC2 may be referred to as a 1st-2 semiconductor pattern 1112, and the first semiconductor pattern 1110 of the third pixel circuit PC3 may be referred to as a 1st-3 semiconductor pattern 1113.

The 1st-1 semiconductor pattern 1111, the 1st-2 semiconductor pattern 1112, and the 1st-3 semiconductor pattern 1113 may be sequentially arranged adjacent to each other in the first direction (x direction). The channel area A1 of the first transistor T1 of each of the 1st-1 semiconductor pattern 1111 and the 1st-2 semiconductor pattern 1112 may have a curved shape to expand the driving range of the first transistor T1. On the other hand, the channel area A1 of the first transistor T1 of the 1st-3 semiconductor pattern 1113 may have a straight shape.

The first conductive layer 1200 may include a first conductive pattern 1210, a second conductive pattern 1220, an emission control line EML, a fourth gate line GBL, and a 2nd-2 initialization voltage line VL2-2.

The first conductive pattern 1210 and the second conductive pattern 1220 may have an isolated shape. The first conductive pattern 1210 may overlap the channel area A1 of the first transistor T1 and may function as a gate electrode G1 of the first transistor T1. The second conductive pattern 1220 may overlap the channel area A2 of the second transistor T2. A portion of the second conductive pattern 1220 overlapping the channel area A2 of the second transistor T2 may function as a gate electrode G2 of the second transistor T2.

The emission control line EML may extend in the first direction (x direction) and may be configured to transmit a fifth gate signal EM (see FIG. 3) to the pixel circuits PC1, PC2, and PC3 arranged in the same row. The emission control line EML may overlap the channel area A5 of the fifth transistor T5 and the channel area A6 of the sixth transistor T6. A portion of the emission control line EML overlapping the channel area A5 of the fifth transistor T5 may function as a gate electrode G5 of the fifth transistor T5, and a portion of the emission control line EML overlapping the channel area A6 of the sixth transistor T6 may function as a gate electrode G6 of the sixth transistor T6.

The fourth gate line GBL may extend in the first direction (x direction) and may be configured to transmit a fourth gate signal GB (see FIG. 3) to the pixel circuits PC1, PC2, and PC3 arranged in the same row. The fourth gate line GBL may overlap the channel area A7 of the seventh transistor T7 and the channel area A8 of the eighth transistor T8. A portion of the fourth gate line GBL overlapping the channel area A7 of the seventh transistor T7 may function as a gate electrode G7 of the seventh transistor T7, and a portion of the fourth gate line GBL overlapping the channel area A8 of the eighth transistor T8 may function as a gate electrode G8 of the eighth transistor T8.

The 2nd-2 initialization voltage line VL2-2 may extend in the first direction (x direction) and may be connected to the 1st-2 semiconductor pattern 1112 through a fourteenth conductive pattern 1670 of the second pixel circuit PC2 and connected to the 1st-3 semiconductor pattern 1113 through a fourteenth conductive pattern 1670 of the third pixel circuit PC3, which will be described below. As described above, the power supply circuit 17 (see FIG. 2) may transmit a different second initialization voltage Vaint (see FIG. 3) for each pixel P (see FIG. 2). The 2nd-2 initialization voltage line VL2-2 may be configured to transmit a 2nd-2 initialization voltage to the seventh transistor T7 of the second pixel circuit PC2 and the seventh transistor T7 of the third pixel circuit PC3.

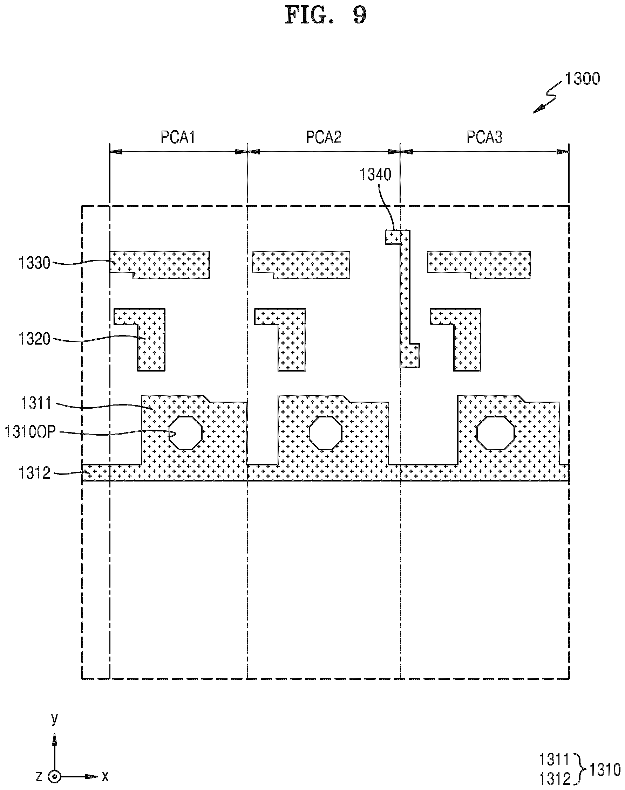

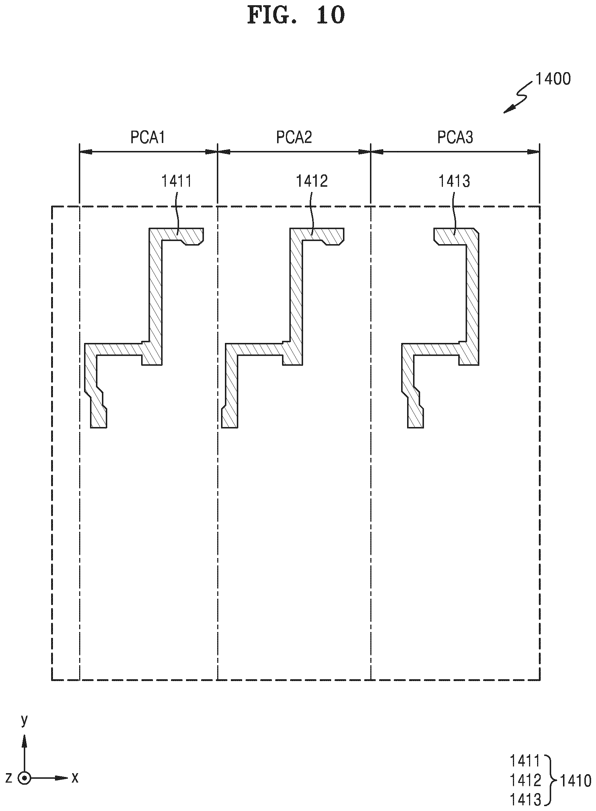

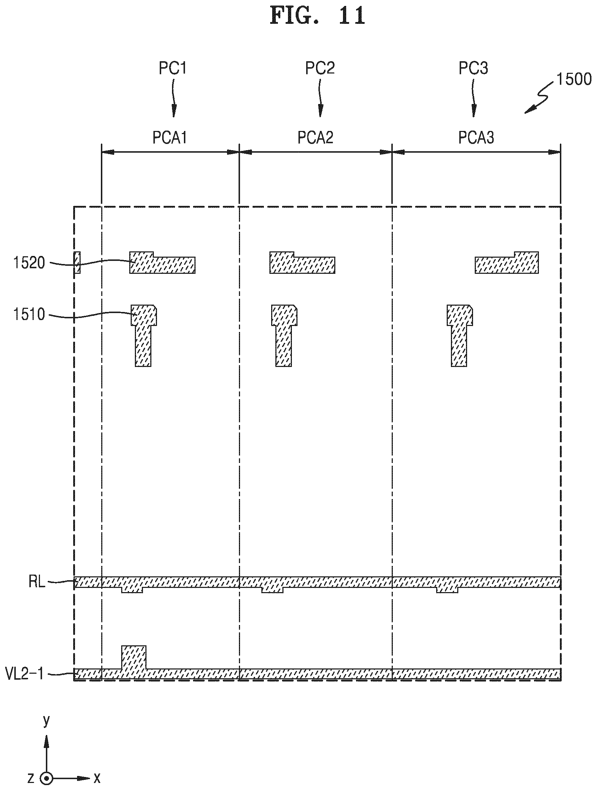

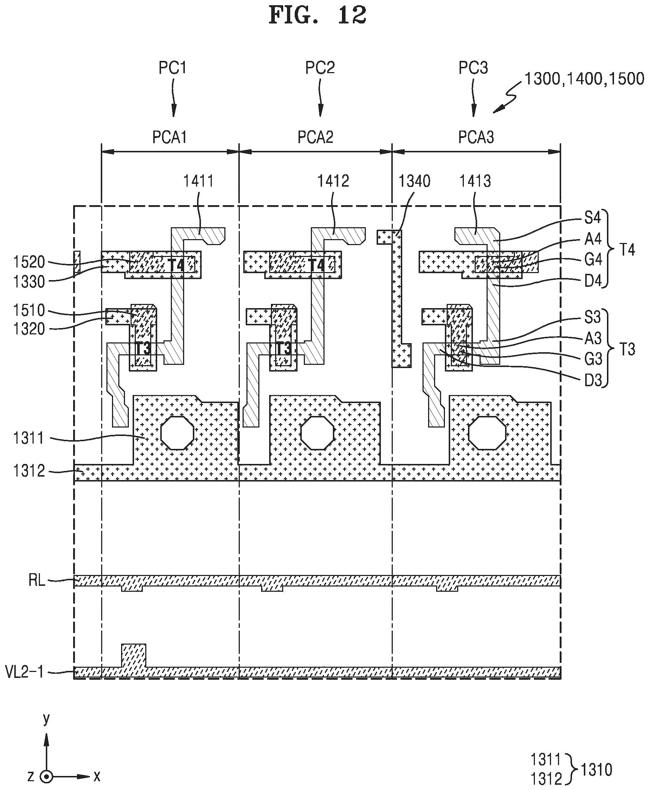

FIG. 9 illustrates a second conductive layer 1300 located over the first conductive layer 1200, FIG. 10 illustrates a second semiconductor layer 1400 located over the second conductive layer 1300, and FIG. 11 illustrates a third conductive layer 1500 located over the second semiconductor layer 1400. For convenience of description, FIG. 12 illustrates the second conductive layer 1300, the second semiconductor layer 1400, and the third conductive layer 1500 in an overlapping manner. At least one insulating layer may be arranged between the first conductive layer 1200 and the second conductive layer 1300, between the second conductive layer 1300 and the second semiconductor layer 1400, and between the second semiconductor layer 1400 and the third conductive layer 1500.

The second conductive layer 1300 and the third conductive layer 1500 may include a conductive material such as molybdenum (Mo), aluminum (Al), copper (Cu), or titanium (Ti) and may include a single layer or multiple layers including the above material. For example, each of the second conductive layer 1300 and the third conductive layer 1500 may have a molybdenum (Mo) single layer structure.

The second semiconductor layer 1400 may include an oxide-based semiconductor material, for example, an oxide of at least one of indium (In), gallium (Ga), stannum (Sn), zirconium (Zr), vanadium (V), hafnium (Hf), cadmium (Cd), germanium (Ge), chromium (Cr), titanium (Ti), aluminum (Al), cesium (Cs), cerium (Ce), or zinc (Zn). The second semiconductor layer 1400 may include In-Ga-Zn-O (IGZO) or In-Sn-Ga-Zn-O (ITGZO).

The second conductive layer 1300 may include a third conductive pattern 1310, a fourth conductive pattern 1320, a fifth conductive pattern 1330, and a sixth conductive pattern 1340. The second semiconductor layer 1400 may include a third semiconductor pattern 1410.

The third semiconductor pattern 1410 may include a channel area A3 of the third transistor T3 and a channel area A4 of the fourth transistor T4. A source area and a drain area may be arranged on both sides of each of the channel areas A3 and A4. Source areas S3 and S4 and drain areas D3 and D4 may be doped areas. The third semiconductor pattern 1410 may include a 3rd-1 semiconductor pattern 1411 arranged in the first area PCA1, a 3rd-2 semiconductor pattern 1412 arranged in the second area PCA2, and a 3rd-3 semiconductor pattern 1413 arranged in the third area PCA3.

For convenience of illustration, FIG. 12 illustrates the gate electrodes, channel areas, source areas, and drain areas of the transistors in the third pixel circuit PC3; however, it may be understood that the gate electrodes G3 and G4, channel areas A3 and A4, source areas S3 and S4, and drain areas D3 and D4 of the third transistor T3 and the fourth transistor T4 are also arranged at the corresponding positions in each of the first pixel circuit PC1 and the second pixel circuit PC2.

The third conductive layer 1500 may include a seventh conductive pattern 1510, an eighth conductive pattern 1520, a repair line RL, and a 2nd-1 initialization voltage line VL2-1.

The third conductive pattern 1310 may include a body portion 1311 and a connection portion 1312 connecting body portions 1311 adjacent to each other in the first direction (x direction). The body portion 1311 of the third conductive pattern 1310 may overlap the first conductive pattern 1210 of the first conductive layer 1200 to form a storage capacitor Cst (see FIG. 3). For example, the first conductive pattern 1210 may function as a lower capacitor electrode of the storage capacitor Cst, and the third conductive pattern 1310 may function as an upper capacitor electrode of the storage capacitor Cst. The third conductive pattern 1310 may define a first hole 1310OP that exposes a portion of the first conductive pattern 1210.

Each of the fourth conductive pattern 1320, the fifth conductive pattern 1330, the seventh conductive pattern 1510, and the eighth conductive pattern 1520 may have an isolated shape. The fourth conductive pattern 1320 may overlap the seventh conductive pattern 1510, and the channel area A3 of the third transistor T3 may be arranged between the fourth conductive pattern 1320 and the seventh conductive pattern 1510. Each of the fourth conductive pattern 1320 and the seventh conductive pattern 1510 may be connected to a second gate line GCL described below and may function as a gate electrode G3 of the third transistor T3. For example, the fourth conductive pattern 1320 may function as a lower gate electrode of the third transistor T3, and the seventh conductive pattern 1510 may function as an upper gate electrode of the third transistor T3.

The fifth conductive pattern 1330 may overlap the eighth conductive pattern 1520, and the channel area A4 of the fourth transistor T4 may be arranged between the fifth conductive pattern 1330 and the eighth conductive pattern 1520. Each of the fifth conductive pattern 1330 and the eighth conductive pattern 1520 may be connected to a third gate line GIL described below and may function as a gate electrode G4 of the fourth transistor T4. For example, the fifth conductive pattern 1330 may function as a lower gate electrode of the fourth transistor T4, and the eighth conductive pattern 1520 may function as an upper gate electrode of the fourth transistor T4.

The sixth conductive pattern 1340 may be arranged between the second pixel circuit PC2 and the third pixel circuit PC3. For example, the sixth conductive pattern 1340 may be arranged across the second area PCA2 and the third area PCA3. The sixth conductive pattern 1340 may be connected to a vertical voltage transmission line VLv described below and any one of the voltage lines extending in the first direction (x direction) (e.g., the first initialization voltage line VL1, the 2nd-1 initialization voltage line VL2-1, and the 2nd-2 initialization voltage line VL2-2). In this regard, FIGS. 4, 9, 12, 13 and 14 illustrate that the sixth conductive pattern 1340 is connected to the vertical voltage transmission line VLv through the first initialization voltage line VL1 and a fifteenth conductive pattern 1680.

The repair line RL may extend in the first direction (x direction). The repair line RL may be arranged such that, when a defect occurs in the pixel circuit, a dummy pixel circuit arranged in a peripheral area PA (see FIG. 1A) may be connected to a light emitting diode corresponding to the defective pixel circuit in replacement of the defective pixel circuit.

The 2nd-1 initialization voltage line VL2-1 may extend in the first direction (x direction) and may be connected to the 1st-1 semiconductor pattern 1111 through a fourteenth conductive pattern 1670 of the first pixel circuit PC1. As described above, the power supply circuit 17 (see FIG. 2) may transmit a different second initialization voltage Vaint (see FIG. 3) for each pixel P (see FIG. 2). The 2nd-1 initialization voltage line VL2-1 may be configured to transmit a 2nd-1 initialization voltage different from the 2nd-2 initialization voltage to the seventh transistor T7 of the first pixel circuit PC1.

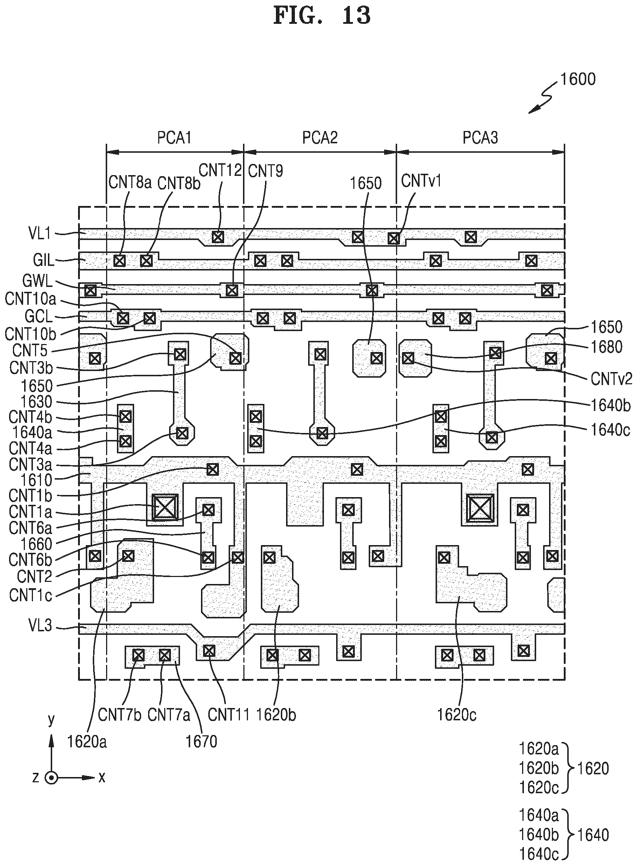

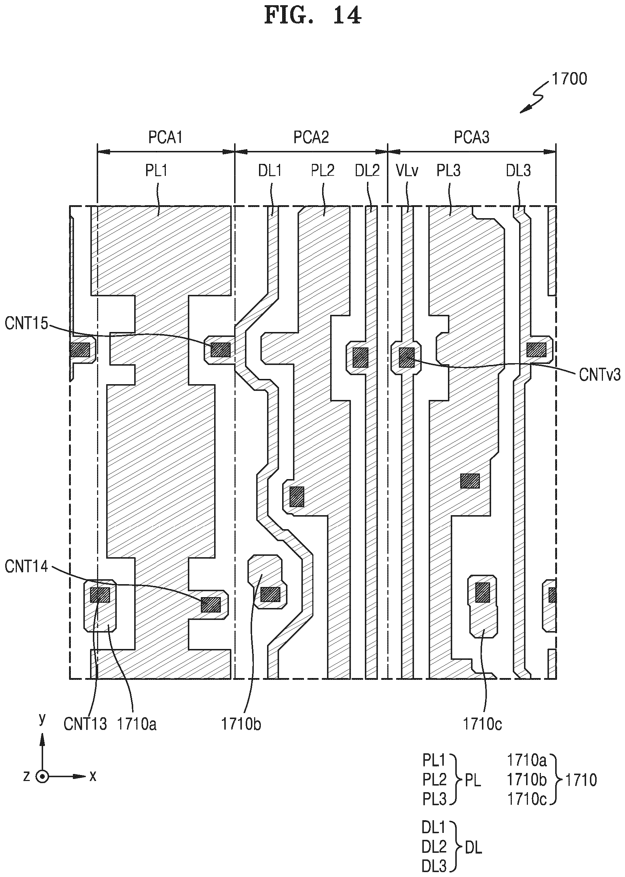

FIG. 13 illustrates a fourth conductive layer 1600 located over the third conductive layer 1500, and FIG. 14 illustrates a fifth conductive layer 1700 located over the fourth conductive layer 1600. At least one insulating layer may be arranged between the third conductive layer 1500 and the fourth conductive layer 1600 and between the fourth conductive layer 1600 and the fifth conductive layer 1700. Each of the fourth conductive layer 1600 and the fifth conductive layer 1700 may include a conductive material such as molybdenum (Mo), aluminum (Al), copper (Cu), or titanium (Ti) and may include a single layer or multiple layers including the above material. For example, each of the fourth conductive layer 1600 and the fifth conductive layer 1700 may have a multilayer structure of Ti/Al/Ti.

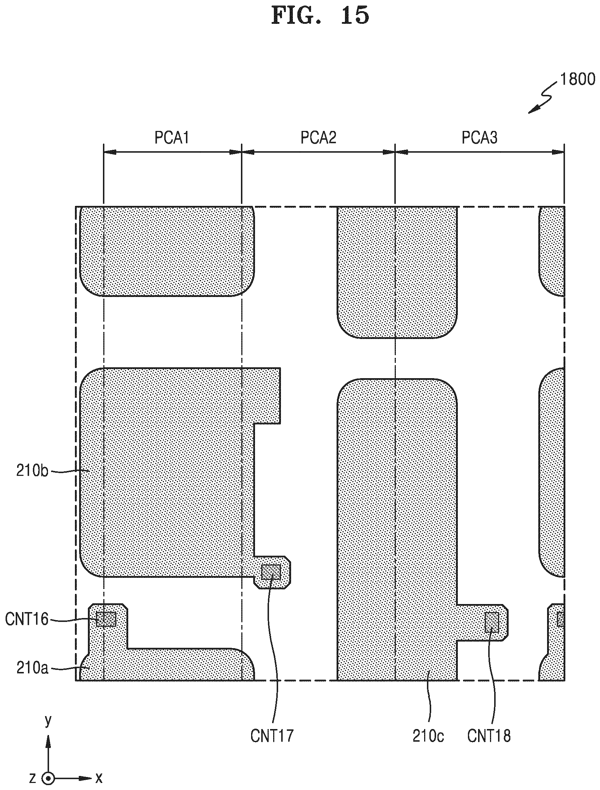

FIG. 15 illustrates a sixth conductive layer 1800 located over the fifth conductive layer 1700. At least one insulating layer may be arranged between the fifth conductive layer 1700 and the sixth conductive layer 1800. The sixth conductive layer 1800 may include a reflective layer including silver (Ag), magnesium (Mg), aluminum (Al), platinum (Pt), palladium (Pd), gold (Au), nickel (Ni), neodymium (Nd), iridium (Ir), chromium (Cr), or any compound thereof, and a transparent or semitransparent conductive layer formed over the reflective layer. The transparent or semitransparent conductive layer may include at least one of indium tin oxide (ITO), indium zinc oxide (IZO), zinc oxide (ZnO), indium oxide (In₂O₃), indium gallium oxide (IGO), and aluminum zinc oxide (AZO). The sixth conductive layer 1800 may have a multilayer structure of ITO/Ag/ITO.

The fourth conductive layer 1600 may include a horizontal voltage transmission line 1610, a ninth conductive pattern 1620, a tenth conductive pattern 1630, an eleventh conductive pattern 1640, a twelfth conductive pattern 1650, a thirteenth conductive pattern 1660, a fourteenth conductive pattern 1670, a fifteenth conductive pattern 1680, a first initialization voltage line VL1, a third gate line GIL, a first gate line GWL, a second gate line GCL, and a bias voltage line VL3.

The fifth conductive layer 1700 may include a sixteenth conductive pattern 1710, a driving voltage line PL, and a data line DL. The sixth conductive layer 1800 may include a first pixel electrode 210a, a second pixel electrode 210b, and a third pixel electrode 210c. The ninth conductive pattern 1620, the tenth conductive pattern 1630, the eleventh conductive pattern 1640, the twelfth conductive pattern 1650, the thirteenth conductive pattern 1660, the fourteenth conductive pattern 1670, the fifteenth conductive pattern 1680, and the sixteenth conductive pattern 1710 may have an isolated shape.

The horizontal voltage transmission line 1610 may extend in the first direction (x direction) and may be connected to the lower conductive layer BML through a 1st-1 contact hole CNT1a, connected to the third conductive pattern 1310 through a 1st-2 contact hole CNT1b, and connected to the first semiconductor pattern 1110 through a 1st-3 contact hole CNT1c. The horizontal voltage transmission line 1610 may be connected to a first driving voltage line PL1, a second driving voltage line PL2, and a third driving voltage line PL3 through fourteenth contact holes CNT14 to transmit a first power voltage ELVDD (see FIG. 3). The horizontal voltage transmission line 1610 may connect the source area S5 of the fifth transistor T5, the upper capacitor electrode of the storage capacitor Cst, and the driving voltage lines PL to each other.

The ninth conductive pattern 1620 may be connected to the first semiconductor pattern 1110 through a second contact hole CNT2 and connected to the sixteenth conductive pattern 1710 through a thirteenth contact hole CNT13. The ninth conductive pattern 1620 and the sixteenth conductive pattern 1710 may connect the drain area D6 of the sixth transistor T6, the source area S7 of the seventh transistor T7, and the pixel electrode of the organic light emitting diode OLED (see FIG. 3) to each other.

The ninth conductive pattern 1620 may include a 9th-1 conductive pattern 1620a arranged in the first area PCA1, a 9th-2 conductive pattern 1620b arranged in the second area PCA2, and a 9th-3 conductive pattern 1620c arranged in the third area PCA3. Likewise, the sixteenth conductive pattern 1710 may include a 16th-1 conductive pattern 1710a arranged in the first area PCA1, a 16th-2 conductive pattern 1710b arranged in the second area PCA2, and a 16th-3 conductive pattern 1710c arranged in the third area PCA3.

The first pixel electrode 210a may be connected to the 16th-1 conductive pattern 1710a through a sixteenth contact hole CNT16, the second pixel electrode 210b may be connected to the 16th-2 conductive pattern 1710b through a seventeenth contact hole CNT17, and the third pixel electrode 210c may be connected to the 16th-3 conductive pattern 1710c through an eighteenth contact hole CNT18. That is, the first pixel electrode 210a may be connected to the first pixel circuit PC1, the second pixel electrode 210b may be connected to the second pixel circuit PC2, and the third pixel electrode 210c may be connected to the third pixel circuit PC3.

The tenth conductive pattern 1630 may be connected to the first conductive pattern 1210 through a 3rd-1 contact hole CNT3a and the first hole 1310OP of the third conductive pattern 1310 and connected to the third semiconductor pattern 1410 through a 3rd-2 contact hole CNT3b. The tenth conductive pattern 1630 may connect the gate electrode G1 of the first transistor T1, the lower capacitor electrode of the storage capacitor Cst, the source area S3 of the third transistor T3, and the drain area D4 of the fourth transistor T4 to each other.

The eleventh conductive pattern 1640 may be connected to the first semiconductor pattern 1110 through a 4th-1 contact hole CNT4a and connected to the third semiconductor pattern 1410 through a 4th-2 contact hole CNT4b. The eleventh conductive pattern 1640 may connect the drain area D3 of the third transistor T3 and the drain area D1 of the first transistor T1 to each other. The eleventh conductive pattern 1640 may be referred to as a connection electrode connecting one terminal of the first transistor T1 and one terminal of the third transistor T3 to each other.

The eleventh conductive pattern 1640 may include an 11th-1 conductive pattern 1640a of the first pixel circuit PC1 arranged in the first area PCA1, an 11th-2 conductive pattern 1640b of the second pixel circuit PC2 arranged in the second area PCA2, and an 11th-3 conductive pattern 1640c of the third pixel circuit PC3 arranged in the third area PCA3. The 11th-1 conductive pattern 1640a may connect the 1st-1 semiconductor pattern 1111 and the 3rd-1 semiconductor pattern 1411 to each other, the 11th-2 conductive pattern 1640b may connect the 1st-2 semiconductor pattern 1112 and the 3rd-2 semiconductor pattern 1412 to each other, and the 11th-3 conductive pattern 1640c may connect the 1st-3 semiconductor pattern 1113 and the 3rd-3 semiconductor pattern 1413 to each other.

The twelfth conductive pattern 1650 may be connected to the first semiconductor pattern 1110 through a fifth contact hole CNT5 and connected to the data line DL through a fifteenth contact hole CNT15. The twelfth conductive pattern 1650 may connect the source area S2 of the second transistor T2 and the data line DL to each other. A first data line DL1 may be connected to the twelfth conductive pattern 1650 of the first pixel circuit PC1, a second data line DL2 may be connected to the twelfth conductive pattern 1650 of the second pixel circuit PC2, and a third data line DL3 may be connected to the twelfth conductive pattern 1650 of the third pixel circuit PC3.

The thirteenth conductive pattern 1660 may be connected to the first semiconductor pattern 1110 through a 6th-1 contact hole CNT6a and connected to the second semiconductor pattern 1120 through a 6th-2 contact hole CNT6b. The thirteenth conductive pattern 1660 may connect the source area S1 of the first transistor T1, the drain area D2 of the second transistor T2, the drain area D5 of the fifth transistor T5, and the drain area D8 of the eighth transistor T8 to each other.

The fourteenth conductive pattern 1670 may be connected to the first semiconductor pattern 1110 through a 7th-1 contact hole CNT7a and connected to the 2nd-1 initialization voltage line VL2-1 or the 2nd-2 initialization voltage line VL2-2 through a 7th-2 contact hole CNT7b. The fourteenth conductive pattern 1670 may connect the drain area D7 of the seventh transistor T7 to the 2nd-1 initialization voltage line VL2-1 or the 2nd-2 initialization voltage line VL2-2. For example, the fourteenth conductive pattern 1670 arranged in the first area PCA1 may connect the 1st-1 semiconductor pattern 1111 to the 2nd-1 initialization voltage line VL2-1, the fourteenth conductive pattern 1670 arranged in the second area PCA2 may connect the 1st-2 semiconductor pattern 1112 to the 2nd-2 initialization voltage line VL2-2, and the fourteenth conductive pattern 1670 arranged in the third area PCA3 may connect the 1st-3 semiconductor pattern 1113 to the 2nd-2 initialization voltage line VL2-2.

The fifteenth conductive pattern 1680 may be arranged between the second pixel circuit PC2 and the third pixel circuit PC3. For example, the fifteenth conductive pattern 1680 may be arranged in the third area PCA3. The fifteenth conductive pattern 1680 may be connected to the sixth conductive pattern 1340 through a 20th contact hole CNTv2 and connected to the vertical voltage transmission line VLv through a 21st contact hole CNTv3.

Each of the first gate line GWL, the second gate line GCL, the third gate line GIL, the first initialization voltage line VL1, and the bias voltage line VL3 may extend in the first direction (x direction). The first gate line GWL may be connected to the second conductive pattern 1220 through a ninth contact hole CNT9. The first gate line GWL may be configured to transmit a first gate signal GW (see FIG. 3) to the gate electrode G2 of the second transistor T2.

The second gate line GCL may be connected to the fourth conductive pattern 1320 through a 10th-1 contact hole CNT10a and connected to the seventh conductive pattern 1510 through a 10th-2 contact hole CNT10b. The second gate line GCL may be configured to transmit a second gate signal GC (see FIG. 3) to the gate electrodes G3 of the third transistor T3.

The third gate line GIL may be connected to the fifth conductive pattern 1330 through an 8th-1 contact hole CNT8a and connected to the eighth conductive pattern 1520 through an 8th-2 contact hole CNT8b. The third gate line GIL may be configured to transmit a third gate signal GI (see FIG. 3) to the gate electrodes G4 of the fourth transistor T4.

The first initialization voltage line VL1 may be connected to the third semiconductor pattern 1410 through a twelfth contact hole CNT12. The first initialization voltage line VL1 may be configured to transmit a first initialization voltage Vint (see FIG. 3) to the source area S4 of the fourth transistor T4. The first initialization voltage line VL1 may be connected to the sixth conductive pattern 1340 through a nineteenth contact hole CNTv1. As described above, the sixth conductive pattern 1340 may be connected to the vertical voltage transmission line VLv through the fifteenth conductive pattern 1680, and the first initialization voltage line VL1 and the vertical voltage transmission line VLv may form a mesh structure.

The bias voltage line VL3 may be connected to the second semiconductor pattern 1120 through an eleventh contact hole CNT11. The bias voltage line VL3 may be configured to transmit a bias voltage Vobs (see FIG. 3) to the source area S8 of the eighth transistor T8.

The driving voltage line PL may include a first driving voltage line PL1 arranged in the first area PCA1, a second driving voltage line PL2 arranged in the second area PCA2, and a third driving voltage line PL3 arranged in the third area PCA3. The first driving voltage line PL1 may overlap the first pixel circuit PC1, the second driving voltage line PL2 may overlap the second pixel circuit PC2, and the third driving voltage line PL3 may overlap the third pixel circuit PC3. Each of the first driving voltage line PL1, the second driving voltage line PL2, and the third driving voltage line PL3 may extend in the second direction (y direction) and may be connected to the horizontal voltage transmission line 1610 through a fourteenth contact hole CNT14. The driving voltage line PL may be configured to transmit a first power voltage ELVDD (see FIG. 3).

The data line DL may include a first data line DL1 connected to the first pixel circuit PC1, a second data line DL2 connected to the second pixel circuit PC2, and a third data line DL3 connected to the third pixel circuit PC3. Each of the first to third data lines DL1, DL2, and DL3 may extend in the second direction (y direction) and may be connected to the twelfth conductive pattern 1650 through a fifteenth contact hole CNT15. The first data line DL1 may be configured to transmit, to the first pixel circuit PC1, a data signal Dm (see FIG. 3) applied to the first pixel, the second data line DL2 may be configured to transmit, to the second pixel circuit PC2, a data signal Dm applied to the second pixel, and the third data line DL3 may be configured to transmit, to the third pixel circuit PC3, a data signal Dm applied to the third pixel. The first pixel may be a red pixel emitting red light, the second pixel may be a green pixel emitting green light, and the third pixel may be a blue pixel emitting blue light. The first driving voltage line PL1, the first data line DL1, the second driving voltage line PL2, the second data line DL2, the third driving voltage line PL3, and the third data line DL3 may be sequentially arranged in the first direction (x direction). In the plan view, the first data line DL1 may have a curved shape to bypass the 11th-2 conductive pattern 1640b and the 16th-2 conductive pattern 1710b of the second pixel circuit PC2 and may overlap the second area PCA2. In the plan view, the 11th-2 conductive pattern 1640b may be arranged between the first driving voltage line PL1 and the first data line DL1.

As a comparative example, when the first data line and the 11th-2 conductive pattern of the second pixel circuit overlap each other in the plan view, because the 11th-2 conductive pattern and the first data line are adjacent to each other in the thickness direction (z direction), a coupling due to parasitic capacitance may occur between the 11th-2 conductive pattern and the first data line. For example, the voltage of the drain area of the first transistor of the second pixel circuit connected to the 11th-2 conductive pattern may increase due to the data signal applied to the first data line. Thus, the luminance of the second organic light emitting diode connected to the second pixel circuit may change due to the data signal applied to the first data line, and thus, a stain may occur in an image displayed by the display apparatus.

On the other hand, the first data line DL1 may be spaced apart from the 11th-2 conductive pattern 1640b by a sufficient distance in the plan view, and thus, the parasitic capacitance between the first data line DL1 and the 11th-2 conductive pattern 1640b may decrease. Thus, the occurrence of a coupling of the 11th-2 conductive pattern 1640b of the second pixel circuit PC2 adjacent to the first data line DL1 may be prevented or reduced. The display apparatus 10 may display a high-quality image by preventing or reducing a change in the luminance of the second pixel circuit PC2 due to the first data line DL1 because the 11th-2 conductive pattern 1640b and the first data line DL1 may be spaced apart from each other by a sufficient distance in the plan view even though they are adjacent to each other in the thickness direction (z direction).

The first data line DL1 may overlap the drain area D1 of the first transistor T1 of the second pixel circuit PC2 in order to bypass the 11th-2 conductive pattern 1640b. In this case, the third conductive pattern 1310 may extend to an area in which the first data line DL1 and the drain area D1 of the first transistor T1 of the second pixel circuit PC2 overlap each other. In other words, the drain area D1 of the first transistor T1 of the second pixel circuit PC2, the third conductive pattern 1310, and the first data line DL1 may overlap each other in the plan view. Because the third conductive pattern 1310 is connected to the horizontal voltage transmission line 1610 to receive the first power voltage ELVDD, the first transistor T1 of the second pixel circuit PC2 may be effectively shielded from the first data line DL1.

In the display area DA (see FIGS. 1A and 1B), the second data line DL2 may have a straight shape extending in the second direction (y direction). The third data line DL3 may extend in the second direction (y direction) and may have a curved shape to be spaced apart from the third driving voltage line PL3 and the pixel electrodes of adjacent pixels P (see FIG. 2).

The vertical voltage transmission line VLv may extend in the second direction (y direction) and may be arranged between the second pixel circuit PC2 and the third pixel circuit PC3. As described above, the vertical voltage transmission line VLv may be connected to any one of the voltage lines (e.g., the first initialization voltage line VL1, the 2nd-1 initialization voltage line VL2-1, and the 2nd-2 initialization voltage line VL2-2) extending in the first direction (x direction) through the sixth conductive pattern 1340 and the fifteenth conductive pattern 1680 and may form a mesh structure.

The first pixel electrode 210a, the second pixel electrode 210b, and the third pixel electrode 210c may be arranged along a certain pattern. For example, the first pixel electrode 210a and the second pixel electrode 210b may be alternately arranged in the second direction (y direction), and the third pixel electrode 210c may be arranged in a stripe array spaced apart from the first pixel electrode 210a and the second pixel electrode 210b in the first direction (x direction).

The first pixel electrode 210a may be a pixel electrode of the first organic light emitting diode of the first pixel that emits red light. The second pixel electrode 210b may be a pixel electrode of the second organic light emitting diode of the second pixel that emits green light. The third pixel electrode 210c may be a pixel electrode of the third organic light emitting diode of the third pixel that emits blue light.

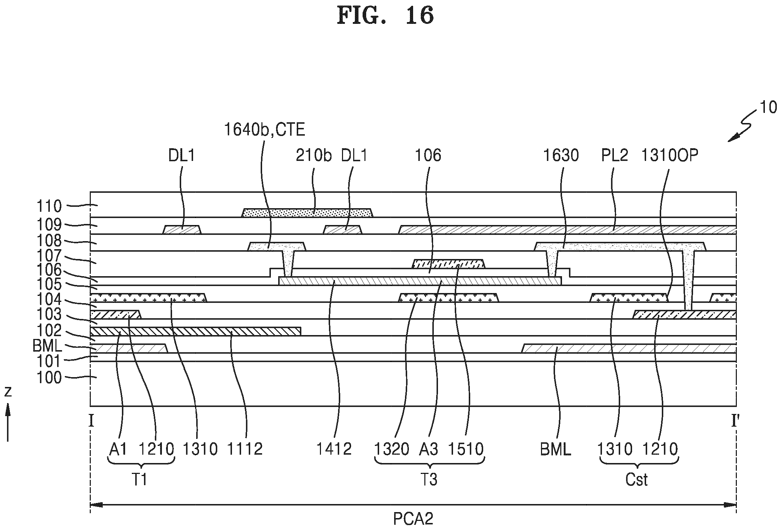

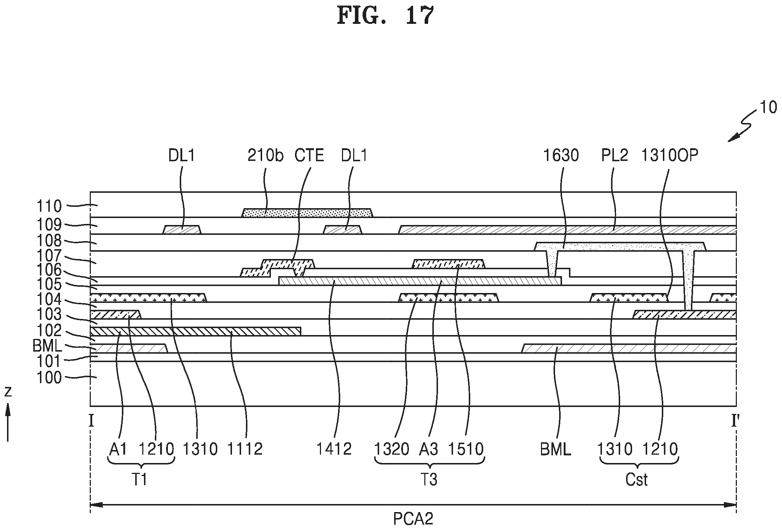

FIGS. 16 and 17 are each a cross-sectional view schematically illustrating a display apparatus. FIG. 16 schematically illustrates a cross-section along the line I-I' of the display apparatus 10 illustrated in FIG. 4.

For convenience of description, each of FIGS. 16 and 17 schematically illustrates a cross-section from a substrate 100 to a pixel definition layer 110 of the display apparatus 10.

Referring to FIGS. 4 and 16 together, the display apparatus 10 may include a substrate 100. Because the components of the display apparatus 10 are located over the substrate 100, it may be said that the substrate 100 includes a first area PCA1, a second area PCA2, and a third area PCA3. A first pixel circuit PC1 may be arranged in the first area PCA1, a second pixel circuit PC2 may be arranged in the second area PCA2, and a third pixel circuit PC3 may be arranged in the third area PCA3.

The substrate 100 may include glass, metal, or polymer resin. The substrate 100 may include a polymer resin such as polyethersulphone, polyacrylate, polyetherimide, polyethylene naphthalate, polyethylene terephthalate, polyphenylene sulfide, polyarylate, polyimide, polycarbonate, or cellulose acetate propionate. The substrate 100 may be variously modified such as including a multilayer structure including two layers including a polymer resin and a barrier layer located between the two layers and including an inorganic material (e.g., silicon oxide, silicon nitride, or silicon oxynitride).

A first insulating layer 101 may be located over the substrate 100, and a lower conductive layer BML may be located over the first insulating layer 101. The first insulating layer 101 may be a barrier layer for blocking the penetration of impurities from the substrate 100. A second insulating layer 102 may be located over the lower conductive layer BML, and a first semiconductor layer 1100 (see FIG. 6) may be located over the second insulating layer 102. The second insulating layer 102 may be a buffer layer for blocking the penetration of impurities from the substrate 100 and providing a flat upper surface.

The first semiconductor layer 1100 may include a 1st-2 semiconductor pattern 1112 including a channel area A1 of the first transistor T1 of the second pixel circuit PC2.

The 1st-2 semiconductor pattern 1112 may include a silicon-based semiconductor material. The body portion of the lower conductive layer BML may overlap the channel area A1 of the first transistor T1 to prevent or reduce degradation of the first transistor T1 due to external light or the like.

A third insulating layer 103 may be located over the first semiconductor layer 1100, and a first conductive layer 1200 (see FIG. 7) may be located over the third insulating layer 103. The third insulating layer 103 may be a first gate insulating layer. The first conductive layer 1200 may include a first conductive pattern 1210. The first conductive pattern 1210 may overlap the channel area A1 of the first transistor T1 over the 1st-2 semiconductor pattern 1112 and may function as a gate electrode of the first transistor T1.

A fourth insulating layer 104 may be located over the first conductive layer 1200, and a second conductive layer 1300 (see FIG. 9) may be located over the fourth insulating layer 104. The second conductive layer 1300 may include a third conductive pattern 1310 and a fourth conductive pattern 1320. The third conductive pattern 1310 may overlap the first conductive pattern 1210 to form a storage capacitor Cst. For example, the first conductive pattern 1210 may function as a lower capacitor electrode of the storage capacitor Cst, and the third conductive pattern 1310 may function as an upper capacitor electrode of the storage capacitor Cst. The third conductive pattern 1310 may define a first hole 1310OP that exposes a portion of the first conductive pattern 1210.

A fifth insulating layer 105 may be located over the second conductive layer 1300, and a second semiconductor layer 1400 (see FIG. 10) may be located over the fifth insulating layer 105. The second semiconductor layer 1400 may include a 3rd-2 semiconductor pattern 1412 located over the 1st-2 semiconductor pattern 1112. The 3rd-2 semiconductor pattern 1412 may include a channel area A3 of the third transistor T3 of the second pixel circuit PC2. The 3rd-2 semiconductor pattern 1412 may include an oxide-based semiconductor material.

A sixth insulating layer 106 may be located over the second semiconductor layer 1400, and a third conductive layer 1500 (see FIG. 11) may be located over the sixth insulating layer 106. The sixth insulating layer 106 may be a second gate insulating layer. The third conductive layer 1500 may include a seventh conductive pattern 1510. The fourth conductive pattern 1320 may overlap the channel area A3 of the third transistor T3 under the 3rd-2 semiconductor pattern 1412 and may function as a lower gate electrode of the third transistor T3. The seventh conductive pattern 1510 may overlap the channel area A3 of the third transistor T3 over the 3rd-2 semiconductor pattern 1412 and may function as an upper gate electrode of the third transistor T3.

A seventh insulating layer 107 may be located over the third conductive layer 1500, and a fourth conductive layer 1600 (see FIG. 13) may be located over the seventh insulating layer 107. The fourth conductive layer 1600 may include a tenth conductive pattern 1630 and an 11th-2 conductive pattern 1640b.

The tenth conductive pattern 1630 may be connected to the 3rd-2 semiconductor pattern 1412 through a contact hole CNT3b (see FIG. 13) passing through the sixth insulating layer 106 and the seventh insulating layer 107 and may be connected to the first conductive pattern 1210 through a contact hole CNT3a (see FIG. 13) passing through the fourth insulating layer 104, the fifth insulating layer 105, the sixth insulating layer 106 and the seventh insulating layer 107. The tenth conductive pattern 1630 may connect one terminal of the third transistor T3 and the gate electrode of the first transistor T1 to each other.

The 11th-2 conductive pattern 1640b may be connected to the 3rd-2 semiconductor pattern 1412 through a contact hole CNT4b (see FIG. 13) passing through the sixth insulating layer 106 and the seventh insulating layer 107 and may be connected to the 1st-2 semiconductor pattern 1112 through a contact hole CNT4a (see FIG. 13) passing through the third insulating layer 103, the fourth insulating layer 104, the fifth insulating layer 105, the sixth insulating layer 106 and the seventh insulating layer 107. The 11th-2 conductive pattern 1640b may function as a connection electrode CTE connecting one terminal of the first transistor T1 and one terminal of the third transistor T3 to each other.

The connection electrode CTE connecting one terminal of the first transistor T1 and one terminal of the third transistor T3 to each other may be included in a conductive layer other than the fourth conductive layer 1600. For example, as illustrated in FIG. 17, the connection electrode CTE may be arranged in the same layer as the gate electrode (the seventh conductive pattern 1510) of the third transistor T3. That is, the connection electrode CTE may be included in the third conductive layer 1500. Alternatively, the display apparatus 10 may further include a seventh conductive layer under the sixth conductive layer 1800, and the connection electrode CTE may be included in the seventh conductive layer.

An eighth insulating layer 108 may be located over the fourth conductive layer 1600, and a fifth conductive layer 1700 (see FIG. 14) may be located over the eighth insulating layer 108. The fifth conductive layer 1700 may include a second driving voltage line PL2 and a first data line DL1 connected to the first pixel circuit PC1.

In order to reduce the parasitic capacitance between the first data line DL1 and the connection electrode CTE, the first data line DL1 may have a curved shape in the plan view to bypass the connection electrode CTE with a sufficient distance therebetween. The first data line DL1 may partially overlap the 1st-2 semiconductor pattern 1112 in order to bypass the connection electrode CTE. An area in which the first data line DL1 and the 1st-2 semiconductor pattern 1112 overlap each other may be a drain area D1 of the first transistor T1. The third conductive pattern 1310 may extend to an area in which the first data line DL1 and the drain area D1 of the first transistor T1 overlap each other, and thus, the drain area D1 of the first transistor T1 may be shielded from the first data line DL1. A portion of the second driving voltage line PL2 may overlap the channel area A3 of the third transistor T3 to shield the third transistor T3 from external light.

A ninth insulating layer 109 may be located over the fifth conductive layer 1700, and a sixth conductive layer 1800 (see FIG. 15) may be located over the ninth insulating layer 109. The sixth conductive layer 1800 may include a second pixel electrode 210b. The second pixel electrode 210b may be a pixel electrode of the second light emitting diode connected to the second pixel circuit PC2. The second pixel electrode 210b may include a protrusion portion overlapping a portion of the 3rd-2 semiconductor pattern 1412 to shield the 3rd-2 semiconductor pattern 1412 from external light.

Each of the first to sixth insulating layers 101, 102, 103, 104, 105, and 106 may include a single layer or multiple layers including an inorganic material such as silicon oxide, silicon nitride, or silicon oxynitride. Each of the seventh insulating layer 107, the eighth insulating layer 108, and the ninth insulating layer 109 may include a single layer or multiple layers including an inorganic material and/or an organic material. Here, the inorganic material may include silicon oxide, silicon nitride, or silicon oxynitride, and the organic material may include acryl, benzocyclobutene (BCB), or hexamethyldisiloxane (HMDSO).

A pixel definition layer 110 may be located over the sixth conductive layer 1800. The pixel definition layer 110 may include at least one organic material selected from among polyimide, polyamide, acrylic resin, benzocyclobutene, and phenol resin.

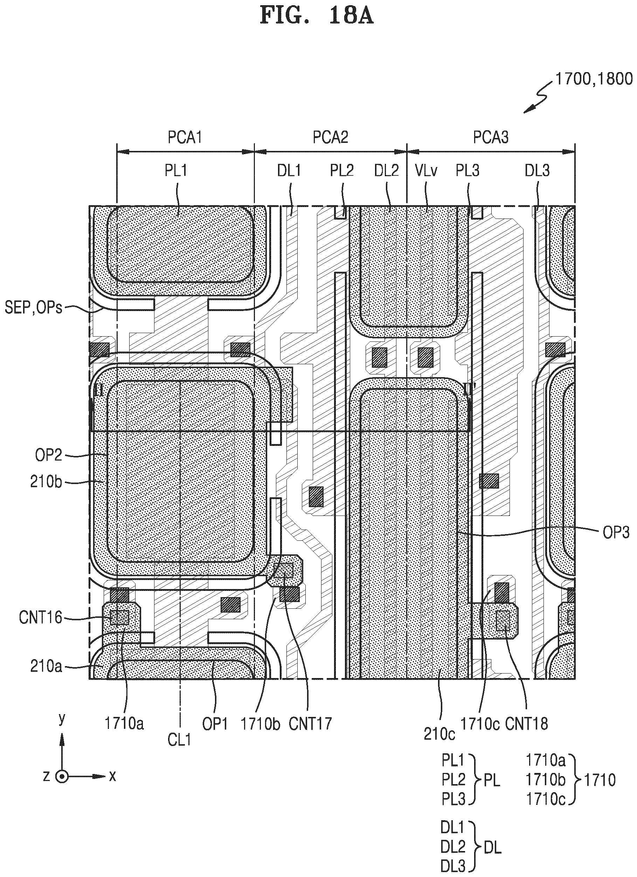

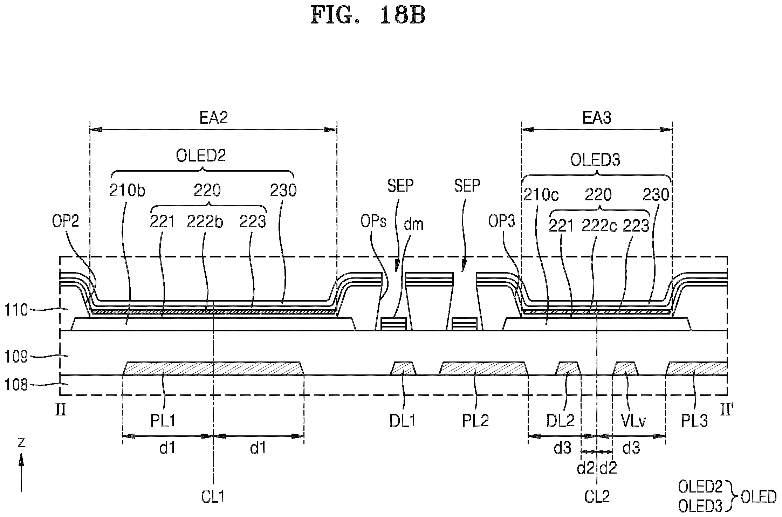

FIG. 18A is a layout diagram schematically illustrating pixel electrodes, voltage lines, and data lines of a display apparatus, and FIG. 18B is a cross-sectional view schematically illustrating a display apparatus. FIG. 18B schematically illustrates a cross-section along the line II-II' of the display apparatus 10 illustrated in FIG. 18A.

For convenience of description, FIG. 18A illustrates a fifth conductive layer 1700, a sixth conductive layer 1800, and openings OP1, OP2, OP3, and OPs of a pixel definition layer 110 in an overlapping manner. FIG. 18B schematically illustrates a cross-section from an eighth insulating layer 108 to an opposite electrode 230 of the display apparatus 10.

Referring to FIG. 18A and FIG. 18B together, a fifth conductive layer 1700 may be located over the eighth insulating layer 108. The fifth conductive layer 1700 may include a driving voltage line PL, a data line DL, sixteenth conductive patterns 1710, and a vertical voltage transmission line VLv.

The driving voltage line PL may include a first driving voltage line PL1 arranged in the first area PCA1 and overlapping the first pixel circuit PC1 (see FIG. 4), a second driving voltage line PL2 arranged in the second area PCA2 and overlapping the second pixel circuit PC2 (see FIG. 4), and a third driving voltage line PL3 arranged in the third area PCA3 and overlapping the third pixel circuit PC3 (see FIG. 4). The data line DL may include a first data line DL1 connected to the first pixel circuit PC1, a second data line DL2 connected to the second pixel circuit PC2, and a third data line DL3 connected to the third pixel circuit PC3. The sixteenth conductive pattern 1710 may include a 16th-1 conductive pattern 1710a of the first pixel circuit PC1, a 16th-2 conductive pattern 1710b of the second pixel circuit PC2, and a 16th-3 conductive pattern 1710c of the third pixel circuit PC3.

The first driving voltage line PL1, the first data line DL1, the second driving voltage line PL2, the second data line DL2, the third driving voltage line PL3, and the third data line DL3 may be sequentially arranged in the first direction (x direction). The vertical voltage transmission line VLv may be arranged between the second pixel circuit PC2 and the third pixel circuit PC3. For example, the vertical voltage transmission line VLv may be arranged between the second data line DL2 and the third driving voltage line PL3.

A ninth insulating layer 109 may be located over the fifth conductive layer 1700, and a sixth conductive layer 1800 may be located over the ninth insulating layer 109. The sixth conductive layer 1800 may include a first pixel electrode 210a connected to the 16th-1 conductive pattern 1710a through the sixteenth contact hole CNT16, a second pixel electrode 210b connected to the 16th-2 conductive pattern 1710b through the seventeenth contact hole CNT17, and a third pixel electrode 210c connected to the 16th-3 conductive pattern 1710c through the eighteenth contact hole CNT18.

The first pixel electrode 210a may be a pixel electrode of a first organic light emitting diode connected to the first pixel circuit PC1, the second pixel electrode 210b may be a pixel electrode of a second organic light emitting diode OLED2 connected to the second pixel circuit PC2, and the third pixel electrode 210c may be a pixel electrode of a third organic light emitting diode OLED3 connected to the third pixel circuit PC3. The first organic light emitting diode may emit red light, the second organic light emitting diode OLED2 may emit green light, and the third organic light emitting diode OLED3 may emit blue light.

The first to third pixel electrodes 210a, 210b, and 210c may be repeatedly arranged along a certain pattern in the first direction (x direction) and the second direction (y direction). For example, the first pixel electrode 210a and the second pixel electrode 210b may be alternately arranged in the second direction (y direction), and the third pixel electrode 210c may be arranged apart from the first pixel electrode 210a and the second pixel electrode 210b in the first direction (x direction).

A pixel definition layer 110 may be located over the fifth conductive layer 1700. The pixel definition layer 110 may define a first pixel opening OP1 overlapping the first pixel electrode 210a, a second pixel opening OP2 overlapping the second pixel electrode 210b, and a third pixel opening OP3 overlapping the third pixel electrode 210c. The pixel definition layer 110 may cover the edge of each of the first pixel electrode 210a, the second pixel electrode 210b, and the third pixel electrode 210c. The pixel definition layer 110 may prevent or reduce instances of an arc or the like occurring at the edge of each of the first pixel electrode 210a, the second pixel electrode 210b, and the third pixel electrode 210c by increasing the distance between the edge of the first pixel electrode 210a and the opposite electrode 230, between the edge of the second pixel electrode 210b and the opposite electrode 230, and between the third pixel electrode 210c and the opposite electrode 230.

The first pixel opening OP1 may define a first emission area of the first light emitting diode and may overlap the first driving voltage line PL1 in the plan view. The second pixel opening OP2 may define a second emission area EA2 of the second organic light emitting diode OLED2 and may overlap the first driving voltage line PL1 in the plan view.

A straight line passing through the center of the first pixel opening OP1 and the center of the second pixel opening OP2 and extended in the second direction (y direction) may be defined as a virtual first straight line CL1. A portion of the first driving voltage line PL1 overlapping the first pixel opening OP1 may be axisymmetric with respect to the virtual first straight line CL1. Likewise, a portion of the first driving voltage line PL1 overlapping the second pixel opening OP2 may be axisymmetric with respect to the virtual first straight line CL1. For example, as illustrated in FIG. 18B, the boundaries on both sides of the first driving voltage line PL1 overlapping the second pixel opening OP2 may be equally spaced apart from the virtual first straight line CL1 by a first distance d1.

The third pixel opening OP3 may define a third emission area EA3 of the third organic light emitting diode OLED3 and may overlap the second driving voltage line PL2, the second data line DL2, the vertical voltage transmission line VLv, and the third driving voltage line PL3 in the plan view. A straight line passing through the center of the third pixel opening OP3 and extending in the second direction (y direction) may be defined as a virtual second straight line CL2. A portion of the second driving voltage line PL2, a portion of the second data line DL2, a portion of the vertical voltage transmission line VLv, and a portion of the third driving voltage line PL3 overlapping the third pixel opening OP3 may be axisymmetric with respect to the virtual second straight line CL2.

For example, as illustrated in FIG. 18B, the boundary of the second data line DL2 and the boundary of the vertical voltage transmission line VLv overlapping the third pixel opening OP3 may be equally spaced apart from the second virtual straight line CL2 by a second distance d2. Likewise, the boundary of the second driving voltage line PL2 and the boundary of the third driving voltage line PL3 overlapping the third pixel opening OP3 may be equally spaced apart from the second virtual straight line CL2 by a third distance d3.

The fifth conductive layer 1700 may be a conductive layer located under the first to third pixel electrodes 210a, 210b, and 210c, and the first to third pixel electrodes 210a, 210b, and 210c may include unevenness formed by the fifth conductive layer 1700. The display apparatus may reduce a luminance deviation for each pixel depending on the viewing angle of the user because the lines overlapping each of the first pixel opening OP1, the second pixel opening OP2, and the third pixel opening OP3 have an axisymmetric shape.

In the plan view, the first data line DL1 may be arranged apart from the first pixel opening OP1 and the second pixel opening OP2 so as not to overlap the first pixel opening OP1 and the second pixel opening OP2. In the plan view, the second data line DL2 may be arranged to overlap the third pixel opening OP3. A portion of the second data line DL2 overlapping the third pixel opening OP3 may be axisymmetric to a portion of the vertical voltage transmission line VLv overlapping the third pixel opening OP3 with respect to the virtual second straight line CL2. The third data line DL3 may be arranged apart from the third pixel opening OP3 so as not to overlap the pixel openings.

An intermediate layer 220 may be arranged over the pixel definition layer 110. The intermediate layer 220 may include a first emission layer, a second emission layer 222b, and a third emission layer 222c. Each of the first emission layer, the second emission layer 222b, and the third emission layer 222c may include a high-molecular-weight or low-molecular-weight organic material that emits light of a certain color. The first emission layer may be patterned corresponding to the first pixel electrode 210a, the second emission layer 222b may be patterned corresponding to the second pixel electrode 210b, and the third emission layer 222c may be patterned corresponding to the third pixel electrode 210c.

The intermediate layer 220 may include a first functional layer 221 located under the first emission layer, the second emission layer 222b, and the third emission layer 222c, and a second functional layer 223 located over the first emission layer, the second emission layer 222b, and the third emission layer 222c. The first functional layer 221 may be a hole transport layer. Alternatively, the first functional layer 221 may include a hole injection layer and a hole transport layer. The second functional layer 223 may include an electron transport layer and/or an electron injection layer. The first functional layer 221 and the second functional layer 223 may be integrally formed to correspond to a plurality of organic light emitting diodes OLED. The first functional layer 221 or the second functional layer 223 may be omitted.

The intermediate layer 220 may include two or more emission units sequentially stacked and a charge generation layer arranged between two emission units. When the intermediate layer 220 includes two or more emission units and a charge generation layer, the organic light emitting diode OLED may be a tandem light emitting device. Because the organic light emitting diode OLED has a stack structure of a plurality of emission units, the color purity and the light emission efficiency thereof may be improved.

One emission unit may include an emission layer and a functional layer under and over the emission layer each. The charge generation layer may include a negative charge generation layer and a positive charge generation layer. The light emission efficiency of the organic light emitting diode OLED that is a tandem light emitting device may be further increased by the negative charge generation layer and the positive charge generation layer.

The negative charge generation layer may be an n-type charge generation layer. The negative charge generation layer may supply electrons. The negative charge generation layer may include a host and a dopant. The host may include an organic material. The dopant may include a metal material. The positive charge generation layer may be a p-type charge generation layer. The positive charge generation layer may supply holes. The positive charge generation layer may include a host and a dopant. The host may include an organic material. The dopant may include a metal material.

An opposite electrode 230 may be located over the intermediate layer 220. The opposite electrode 230 may include lithium (Li), silver (Ag), magnesium (Mg), aluminum (Al), aluminum-lithium (Al-Li), calcium (Ca), magnesium-indium (Mg-In), magnesium-silver (Mg-Ag), ytterbium (Yb), silver-ytterbium (Ag-Yb), indium tin oxide (ITO), indium zinc oxide (IZO), or any combination thereof. The opposite electrode 230 may be a transparent electrode, a semitransparent electrode, or a reflective electrode. The opposite electrode 230 may be integrally formed to correspond to a plurality of organic light emitting diodes OLED.

When the organic light emitting diodes OLED are tandem light emitting devices, the functional layers included in the intermediate layer 220 may have relatively high electrical conductivity. The display apparatus 10 may include separators SEP for reducing a leakage current between adjacent organic light emitting diodes OLED. For example, the pixel definition layer 110 may define auxiliary openings OPs surrounding a portion of the first pixel opening OP1, a portion of the second pixel opening OP2, and a portion of the third pixel opening OP3. The auxiliary openings OPs may function as a separator SEP. The auxiliary openings OPs may be arranged apart from the first pixel opening OP1, the second pixel opening OP2, and the third pixel opening OP3. As illustrated in FIG. 18B, the side surface of the auxiliary opening OPs may have a reverse taper shape. That is, the side surface of the pixel definition layer 110 defining the auxiliary opening OPs may have an undercut structure.

Common layers integrally formed corresponding to a plurality of organic light emitting diodes OLED, for example, the first functional layer 221, the second functional layer 223, and the opposite electrode 230, may be disconnected by the separators SEP or may include a discontinuous portion having a smaller thickness than a surrounding area. For example, as illustrated in FIG. 18B, the first functional layer 221, the second functional layer 223, and the opposite electrode 230 arranged on the upper surface of the pixel definition layer 110 may be spaced and separated from a dummy layer dm arranged on the bottom surface of the auxiliary opening OPs. However, because the separators SEP do not completely surround each of the first pixel opening OP1, the second pixel opening OP2, and the third pixel opening OP3, the opposite electrodes 230 may be connected to each other and integrally formed in the display area DA (see FIG. 1A).

An encapsulation layer may be located over the organic light emitting diodes OLED. The encapsulation layer may include at least one inorganic layer and at least one organic layer.

As described above, according to some embodiments, a display apparatus displaying a high-quality image may be implemented by reducing the parasitic capacitance between a data line and a driving transistor. However, the disclosure is not limited to these effects.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope of the invention as defined by the following claims.

## Claims

1. A display apparatus comprising:
a substrate (100);
a first pixel circuit (PC1) and a second pixel circuit (PC2) on the substrate (100) and adjacent to each other in a first direction; and
a first conductive layer (1700) over the first pixel circuit (PC1) and the second pixel circuit (PC2) and comprising a first data line (DL1) connected to the first pixel circuit (PC1), a second data line (DL2) connected to the second pixel circuit (PC2), a first voltage line (PL1) overlapping the first pixel circuit (PC1), and a second voltage line (PL2) overlapping the second pixel circuit (PC2),
wherein each of the first pixel circuit (PC1) and the second pixel circuit (PC2) comprise:
a first transistor (T1) comprising a first semiconductor pattern (1111, 1112) and a first gate electrode (1210) over the first semiconductor pattern (1111, 1112);
a second transistor (T3) comprising a second semiconductor pattern (1411, 1412) over the first semiconductor pattern (1111, 1112) and a second gate electrode (1510) over the second semiconductor pattern (1411, 1412); and
a connection electrode (1640) connecting one terminal of the first transistor (T1) and one terminal of the second transistor (T3) to each other,
wherein the connection electrode (1640b) of the second pixel circuit (PC2) is between the first voltage line (PL1) and the first data line (DL1) in a plan view.

2. The display apparatus of claim 1, further comprising:
a second conductive layer (1800) over the first conductive layer (1700) and comprising a first pixel electrode (210a) connected to the first pixel circuit (PC1) and a second pixel electrode (210b) connected to the second pixel circuit (PC2); and
a pixel definition layer (110) over the second conductive layer (1800) and defining a first pixel opening (OP1) overlapping the first pixel electrode (210a) and a second pixel opening (OP2) overlapping the second pixel electrode (210b),
wherein the first data line (DL1) is spaced apart from the first pixel opening (OP1) and the second pixel opening (OP2) in the plan view.

3. The display apparatus of claim 2, wherein the first pixel opening (OP1) and the second pixel opening (OP2) overlap the first voltage line (PL1).

4. The display apparatus of claim 3, wherein a portion of the first voltage line (PL1) overlapping the first pixel opening (OP1) is axisymmetric with respect to a virtual straight line passing through a center of the first pixel opening (OP1).

5. The display apparatus of claim 2, further comprising a third pixel circuit (PC3) over the substrate (100) and adjacent to the second pixel circuit (PC2) in the first direction,
wherein the first conductive layer (1700) further comprises a third data line (DL3) connected to the third pixel circuit (PC3) and a third voltage line (PL3) overlapping the third pixel circuit (PC3).

6. The display apparatus of claim 5, wherein the second conductive layer (1800) further comprises a third pixel electrode (210c) connected to the third pixel circuit (PC3),
the pixel definition layer (110) further defines a third pixel opening (OP3) overlapping the third pixel electrode (210c), and
the second data line (DL2) overlaps the third pixel opening (OP3).

7. The display apparatus of claim 6, wherein the first conductive layer (1700) further comprises a first voltage transmission line (VLv) extending in a second direction intersecting with the first direction and overlapping the third pixel opening (OP3), and
a portion of the first voltage transmission line (VLv) and a portion of the second data line (DL2) overlapping the third pixel opening (OP3) are axisymmetric with respect to a virtual straight line passing through a center of the third pixel opening (OP3).

8. The display apparatus of any one of the preceding claims, wherein each of the first pixel circuit (PC1) and the second pixel circuit (PC2) further comprise a conductive pattern (1310) over the first gate electrode (1210), and
the conductive pattern (1310) of the second pixel circuit (PC2) extends to an area in which the first data line (DL1) and a drain area of the first transistor (T1) of the second pixel circuit (PC2) overlap each other.

9. The display apparatus of claim 8, further comprising a third conductive layer (1600) over the conductive pattern (1310) and comprising a second voltage transmission line (1610) connected to the first voltage line (PL1) , the second voltage line (PL2), and the conductive pattern (1310).

10. The display apparatus of claim 1, further comprising:
a first semiconductor layer (1100) on the substrate (100);
a fourth conductive layer (1200) over the first semiconductor layer (1100);
a fifth conductive layer (1300) over the fourth conductive layer (1200) and comprising a conductive pattern (1310);
a second semiconductor layer (1400) over the fifth conductive layer (1300);
a sixth conductive layer (1500) over the second semiconductor layer (1400) and under the first conductive layer (1700);
a second conductive layer (1800) over the first conductive layer (1700); and
a pixel definition layer (110) over the second conductive layer (1800),
wherein the first semiconductor layer (1100) comprises the first semiconductor pattern (1111, 1112) of each of the first pixel circuit (PC1) and the second pixel circuit (PC2),
the second semiconductor layer (1400) comprises the second semiconductor pattern (1411, 1412) of each of the first pixel circuit (PC1) and the second pixel circuit (PC2),
the second conductive layer comprises a first pixel electrode (210a) connected to the first pixel circuit (PC1) and a second pixel electrode (210b) connected to the second pixel circuit (PC2), and
the pixel definition layer (110) defines a first pixel opening (OP1) overlapping the first pixel electrode (210a) and a second pixel opening (OP2) overlapping the second pixel electrode (210b).

11. The display apparatus of claim 10, wherein the first data line (DL1) is connected to the first semiconductor pattern (1111) of the first pixel circuit (PC1), and the second data line (DL2) is connected to the first semiconductor pattern (1112) of the second pixel circuit (PC2).

12. The display apparatus of claims 10 and 11, further comprising a third pixel circuit (PC3) over the substrate (100) and adjacent to the second pixel circuit (PC2) in the first direction,
wherein the first conductive layer (1700) further comprises a first voltage transmission line (VLv), a third voltage line (PL3) and a third data line (DL3) sequentially arranged from the second data line (DL2) in the first direction,
the second conductive layer (1800) further comprises a third pixel electrode (210c) overlapping the second voltage line (PL2), the second data line (DL2), the first voltage transmission line (VLv), and the third voltage line (PL3), and
the pixel definition layer (110) further defines a third pixel opening (OP3) overlapping the third pixel electrode (210c).

13. The display apparatus of claim 12, further comprising a third conductive layer (1600) comprising a second voltage transmission line (1610) connected to the first voltage line (PL1) , the second voltage line (PL2), and the conductive pattern (1310), and
the third conductive layer (1600) is between the sixth conductive layer (1500) and the first conductive layer (1700).

14. The display apparatus of claims 10, 11, 12, and 13, wherein the conductive pattern (1310) comprises body portions (1311) and a connection portion (1312) connecting the body portions (1311), and
the body portion (1311) of the first pixel circuit (PC1) extends to an area in which the first data line (DL1) and the first semiconductor pattern (1112) of the second pixel circuit (PC2) overlap each other.

15. The display apparatus of any one of the preceding claims, wherein the first semiconductor pattern (1111, 1112) comprises a silicon-based semiconductor material, and the second semiconductor pattern (1411, 1412) comprises an oxide-based semiconductor material.
